(19) Europäisches Patentamt
European Patent Office
Office européen des brevets

(11) **EP 4 166 270 B1**

(12) **EUROPÄISCHE PATENTSCHRIFT**

(45) Veröffentlichungstag und Bekanntmachung des Hinweises auf die Patenterteilung:
**16.10.2024   Patentblatt 2024/42**

(21) Anmeldenummer: **22196085.9**

(22) Anmeldetag: **22.03.2017**

(51) Internationale Patentklassifikation (IPC):
**B23K 26/36** (2014.01)     **B23K 26/00** (2014.01)
**B23K 26/362** (2014.01)     **B23K 26/402** (2014.01)
**B23K 26/53** (2014.01)     **C03B 33/04** (2006.01)
**C03B 33/09** (2006.01)     **B23K 103/00** (2006.01)

(52) Gemeinsame Patentklassifikation (CPC):
**B23K 26/362; B23K 26/0006; B23K 26/402; B23K 26/53; C03B 33/0222; C03B 33/04;**
B23K 2103/52; B23K 2103/54; B23K 2103/56

(54) **VERFAHREN ZUM ABTRENNEN DURCH LASERBESTRAHLUNG EINER FESTKÖRPERSCHICHT VON EINEM FESTKÖRPER**

METHOD OF SEPARATING A LAYER FROM A SOLID BY LASER RADIATION

PROCÉDÉ DE SÉPARATION D'UNE COUCHE D'UN SOLIDE PAR RAYONNEMENT LASER

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.03.2016   DE 102016003556
12.12.2016   PCT/EP2016/080667
12.12.2016   DE 102016014821**

(43) Veröffentlichungstag der Anmeldung:
**19.04.2023   Patentblatt 2023/16**

(62) Dokumentnummer(n) der früheren Anmeldung(en) nach Art. 76 EPÜ:
**17712966.5 / 3 433 048**

(73) Patentinhaber: **Siltectra GmbH**
**01099 Dresden (DE)**

(72) Erfinder:
• **RIESKE, Ralf**
**01099 Dresden (DE)**
• **SWOBODA, Marko**
**01097 Dresden (DE)**
• **RICHTER, Jan**
**01277 Dresden (DE)**

(74) Vertreter: **Westphal, Mussgnug  & Partner, Patentanwälte mbB**
**Werinherstraße 79**
**81541 München (DE)**

(56) Entgegenhaltungen:
DE-A1- 102013 016 682     DE-A1- 102014 214 940
JP-A- 2006 142 556

**Beschreibung**

Die Vorliegende Erfindung bezieht sich gemäß dem Oberbegriff des Anspruchs 1 (siehe z.B. DE 10 2014 214940 A1) auf ein Verfahren zum Abtrennen von mindestens einer Festkörperschicht von einem Festkörper.

Halbleitermaterialien werden z.B. in großen Zylindern aus kristallinem Material, sogenannten Ingots gewachsen, während Industrieprozesse oft Wafermaterial mit unterschiedlicher Dicke und Oberflächenqualität erfordern. Wafering von spröden Halbleitermaterialien wird häufig mit Diamant- oder Slurry-basierten Drahtsäge-Prozessen durchgeführt. Diese Sägeprozesse führen nicht nur zu Schnittspalt-Verlust von potenziell wertvollem Material, sondern auch Oberflächenrauhheit und unter der Oberfläche zur Beschädigung des Kristalls. Diese Aspekte des Wafering mit Sägeprozessen machen erforderlichen Polier- und Schleifschritte im Waferherstellungsprozess erforderlich, was zu zusätzlichen Schäden und Prozesskosten führt.

Um diese Probleme beim herkömmlichen Wafering und Dünnen von Halbleitern anzugehen, wurden sog. *kerf-less* Technologien entwickelt, die eine Verringerung der Schnittspaltverluste versprechen - wenn nicht gar deren Beseitigung, sowie von Schaden unter der Oberfläche und Schleifprozessschritten. Insbesondere extern angelegten sogenannten Spalling-processes Verwendung Beanspruchungen - oft temperaturbedingten - kristalline Materialien entlang Kristallebenen mit gut definierten Dicke zu trennen. Spalling können mit Nickel-Chrom-Legierungen, Silber-Aluminiumpaste, Epoxidharz, Aluminium und Nickel erfolgen. Kerf-freie Wafering-Techniken haben das Potenzial, um Schäden in Halbleiterherstellungsverfahren drastisch zu reduzieren. Spannungsbasierte Abtrennverfahren, wie das sog. Spalling (bzw. Splitten), verwenden extern aufgebrachte Spannungen um kristalline Materialien entlang ihrer Kristallebenen mit gut definierter Dicke zu trennen. Substrate zeigen nach dem Spalling jedoch sogenannte Wallner-Linien, die von der Rissausbreitung im Kristall herrühren.

Es wurde Spalling unter Verwendung von Unterschieden in den thermischen Ausdehnungskoeffizienten zwischen einem spröden Material und einem auf der Oberfläche des Materials anhaftenden Polymer ermöglicht. Abkühlen der verbundenen Materialien unterhalb der Glasübergangstemperatur des Polymers induziert Spannungen, die zur Materialtrennung entlang einer Rissebene führen. Ein Vorteil dieses speziellen Verfahrens im Gegensatz zu anderen Arten von Spalling ist, dass durch den Prozess des Kühlens keine erhöhte Diffusion von unerwünschten chemischen Komponenten durch das Material auftritt, im Gegensatz zu Hochtemperaturverfahren, die auch zum Spalling verwendet werden.

Spalling Verfahren neigen jedoch dazu, in ihrer Kontrolle über die erreichte Wafer-Dicke begrenzt zu sein, und ein Abstimmen des vertikalen Orts der Rissausbreitung ist kompliziert. Darüber hinaus entstehen beim Spalling sehr prominente Muster von Wallner-Linien auf der Oberfläche. Dieses Muster besteht aus streifenförmigen Rillen und Erhebungen, die von der Rissausbreitung im Halbleitermaterial stammen und eine Ableitung der Rissdynamik im Substrat ermöglichen. Üblicherweise beginnt der Riss an einem gewissen Punkt am Rand und breitet sich dann rasch von der Kante des Substrats aus. Wallner-Linien von herkömmlichen Spalling-Oberflächen erhöhen die resultierende Oberflächenrauhigkeit stark, oft bis zu dem Punkt, ab dem vor der Weiterverarbeitung und der Herstellung von Schaltkreisen auf dem Substrat zusätzliche Polier- oder Schleif Schritte erforderlich sind.

Als eine Lösung, um die Wallner-Muster zu beseitigen, wurde ein Prozessschritt mit einer Laseranlage eingeführt, der vor dem eigentlichen Spalling-Prozess stattfindet. Diese Methode wird als lasergestütztes Spalling (laser-assisted spalling - LAS) bezeichnet. Hier ist die horizontale Ebene der Rissausbreitung durch die Bearbeitungsebene des Materials mit kurzen Laserpulsen und hoher numerischer Apertur der Optik definiert. Da die Laserphotonenenergie unterhalb der Materialbandlückenenergie gewählt wird, ist das Material somit durchlässig für die Laserstrahlung, so dass ein tiefes Eindringen ins Material erreicht werden kann. Durch Translation der Fokussierungsoptik entlang der optischen Achse kann die Ebene der Lasermodifikation beliebig festgelegt werden und wird durch die Brennebene der Fokussierungsoptik definiert, die mit Mikrometer-Präzision eingestellt werden kann.

Es ist die Aufgabe der vorliegenden Erfindung das bekannte Fertigungsverfahren zu verbessen, insbesondere effizienter zu machen oder zu beschleunigen. Die zuvor genannte Aufgabe wird erfindungsgemäß durch ein Verfahren gemäß Anspruch 1 gelöst.

Weitere vorteilhafte Ausführungsbeispiele dieser Erfindung sind in den abhängigen Ansprüchen definiert.

Dann bezieht sich die vorliegende Erfindung auf ein Verfahren zum Abtrennen von mindestens einer Festkörperschicht bzw. Festkörperlage, insbesondere einer Festkörperscheibe, von einem Festkörper bzw. Spendersubstrat. Das erfindungsgemäße Verfahren umfasst dabei bevorzugt mindestens die Schritte: Bereitstellen eines Festkörpers, Erzeugen von Modifikationen im Inneren des Festkörpers mittels LASER-Strahlen, wobei durch die Modifikationen ein Ablösebereich bzw. Rissführungsbereichs vorgegeben wird, entlang dem eine Abtrennung der Festkörperschicht von dem Festkörper erfolgt, Abtragen von Material des Festkörpers, insbesondere zum Erzeugen einer umlaufenden Vertiefung, wobei durch den Materialabtrag der Ablösebereich freigelegt wird.

Abtrennen der Festkörperschicht von dem Festkörper. Bevorzugt erfolgt das Abtrennen der Festkörperschicht von dem Festkörper dadurch, dass der Festkörper im Rissführungsbereich durch die Modifikationen derart geschwächt wird, dass sich die Festkörperschicht infolge des Materialabtrags von dem Festkörper ablöst oder nach dem Materialabtrag eine solche Anzahl an Modifikationen erzeugt wird, dass der Festkörper im Rissführungsbereich derart geschwächt wird, dass sich die Festkörperschicht von dem Festkörper ablöst oder eine Spannungserzeugungsschicht an einer zur umlaufenden Oberfläche geneigt ausgerichteten, insbesondere ebenen, Oberfläche des Festkörpers erzeugt oder angeordnet wird und durch ein thermisches Beaufschlagen der Spannungserzeugungsschicht mechanische Spannungen in dem Festkörper erzeugt werden, wobei durch die mechanischen Spannungen ein Riss zum Abtrennen einer Festkörperschicht entsteht, der sich ausgehend von der durch den Materialabtrag freigelegten Oberfläche des Festkörpers entlang der Modifikationen ausbreitet oder der Festkörper nach der Erzeugung der Modifikationen thermisch beaufschlagt, insbesondere abgekühlt, wird und sich infolge der thermischen Beaufschlagung die Festkörperschicht von dem Festkörper entlang des Rissführungsbereichs ablöst.

Somit weist der Schritt des Anordnens oder Erzeugens einer Aufnahmeschicht an dem Festkörper bevorzugt das Merkmale auf, dass die Aufnahmeschicht ein Polymermaterial, insbesondere Polydimethylsiloxan oder ein Elastomer oder ein Epoxidharz oder eine Kombination daraus, aufweist oder daraus besteht, und das Polymermaterial infolge einer thermischen Beaufschlagung der Aufnahmeschicht zum, insbesondere mechanischen, Erzeugen von Rissausbreitungsspannungen in dem Festkörper einen Glasübergang erfährt, wobei sich durch die Rissausbreitungsspannungen ein Riss in dem Festkörper entlang dem Rissführungsbereich ausbreitet.

Darin zeigt beispielhaft:

Fig. 1 schematisch den Ausgleich von Materialeigenschaften durch Anpassung der Laserbeaufschlagung in Abhängigkeit von lokalen Eigenschaftsunterschieden des Materials;

Fig. 2a schematisch die Erzeugung einer Modifikation, die ausreicht um einen Riss zu führen;

Fig. 2b schematisch die Erzeugung einer Modifikation, die gegenüber der Modifikation aus Fig. 2a eine deutlich stärkere Ausdehnung in Längsrichtung des Festkörpers aufweist und nach der Abspaltung der Festkörperschicht dazu führt, dass sich die Festkörperschicht wölbt bzw. biegt;

Fig. 3 schematisch das Erzeugen eines Grabens in einem Festkörper, wobei der Graben zur äußeren umlaufenden Oberfläche des Festkörpers bevorzugt beabstandet ist;

Fig. 4a schematisch eine Anordnung, in der sich Partikel, wie z.B. Staub, in dem Verlauf der Laserstrahlung ansammeln, insbesondere im Kreuzungspunkt der reflektierten Strahlen;

Fig. 4b schematisch eine Anordnung, in der eine Spülung, insbesondere mittels Gas, wie z.B. ionisiertes Gas, vorgesehen ist, die Partikel aus dem Kreuzungspunkt der reflektierten Strahlen entfernt;

Fig. 5 schematisch eine Anordnung, gemäß der eine oder mehrere Beschichtung/en auf dem Festkörper angeordnet sind, wobei die Beschichtung/en bevorzugt mindestens eine andere optische Eigenschaft aufweist bzw. aufweisen als der Festkörper;

Fig. 6a schematisch die Einstrahlung von Laserstrahlen im Brewster-Winkel;

Fig. 6b Verläufe zum Verdeutlichen des Zusammenhangs zwischen Einstrahlwinkel und Reflexion;

Fig. 7-18 jeweils Beispiele für die Berechnung des optimalen Einstrahlwinkels für ein 1/e2 Gauss-Profil und verschiedene numerische Aperturen unter Berücksichtigung der Brechzahlabhängigkeit der Oberflächenreflexion;

Fig. 19a schematisch den Verlauf des Cold-Split-Verfahrens;

Fig. 19b schematisch den Verlauf des Laser-Assisted-Spalling-Verfahrens;

Fig. 19c ein Foto einer gemäß dem Verfahren 19a freigelegten Oberfläche einer Festkörperschicht;

Fig. 19d ein Foto einer gemäß dem Verfahren 19b freigelegten Oberfläche einer Festkörperschicht;

Fig. 20a-f REM-Aufnahmen von Oberflächen;

Fig. 21a eine mikroskopische Aufnahme einer Oberfläche nach dem Spalling;

Fig. 21b Raman-Spektren von drei verschiedenen Stellen in 6H-Siliziumkarbid;

Fig. 22 ein Beispiel für ein Laserstrahlprofil; und

Fig. 23a schematisch ein Beispiel für die sich infolge einer ersten Anzahl an Modifikationen und/oder Modifikationslagen ergebende Biegung der erzeugten Festkörperschicht; und

Fig. 23b schematisch ein weiteres Beispiel für die sich infolge einer zweiten Anzahl an Modifikationen und/oder Modifikationslagen ergebende Biegung der erzeugten Festkörperschicht, wobei die zweite Anzahl größer ist als die erste Anzahl und

Fig. 24a einen schematischen Aufbau eines Raman-Instruments, wie es bevorzugt erfindungsgemäß verwendet wird, insbesondere wie es bevorzugt Bestandteil der erfindungsgemäßen Vorrichtung

Fig. 24b SiC,    verschiedene exemplarische Schwingungszustände der Gitterschwingungen von

Fig. 25a    und 25b zwei Schaubilder, welche Dotierkonzentrationen in einem Festkörper darstellen;

Fig. 26a    einen erfindungsgemäßen Feedforwardprozess und

Fig. 26b    einen erfindungsgemäßen Feedbackprozess.

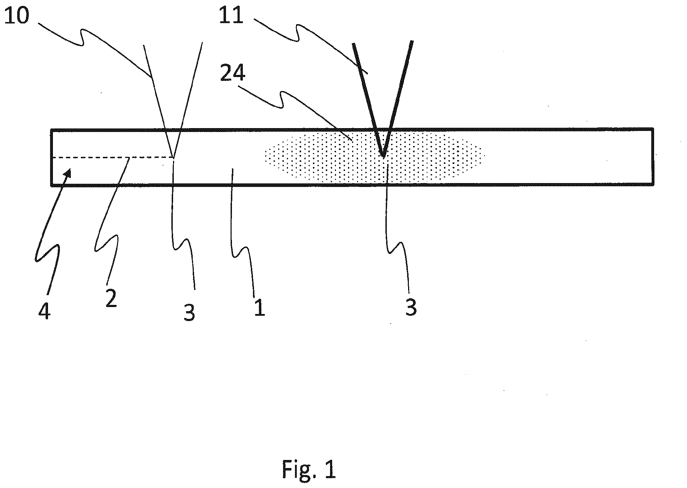

In Fig. 1 ist schematisch ein Aufbau zum Ausführen eines Verfahrens zum Abtrennen von mindestens einer Festkörperschicht 14 von einem Festkörper 1 gezeigt. Durch die Modifikationen 2 ein Rissführungsbereich 4 zum Führen eines Risses zum Abtrennen eines Festkörperanteils 14, insbesondere einer Festkörperschicht, von dem Festkörper 1 vorgegeben wird. Dadurch, dass die Laserstrahlen 10, 11 an verschiedenen Orten des Festkörpers 1 dargestellt sind, ist ersichtlich, dass der Festkörper 1 relativ zu einer Laserbeaufschlagungseinrichtung 8 bewegt wird. Die gezeigten Laserstrahlen 10 und 11 stellen somit Situationen zu unterschiedlichen Zeitpunkten dar. Grundsätzlich erfolgt die Erzeugen von Laserstrahlen 10 mittels der Laserbeaufschlagungseinrichtung 8 zum Erzeugen von jeweils mindestens einer Modifikation 2, wobei die Laserbeaufschlagungseinrichtung 8 zur definierten Modifikationserzeugung in Abhängigkeit von zumindest einem Parameter nämlich der Transmission des Festkörpers 1 an definierten Stellen und für eine definierte Festkörpertiefe eingestellt wird. In der Darstellung gemäß Fig. 1 repräsentieren die Laserstrahlen 10, 11 somit Laserstrahlen mit unterschiedlichen Eigenschaften bzw. mit mindestens einer unterschiedlichen Eigenschaft. Die von Laserstrahl 10 zu Laserstrahl 11 veränderte Eigenschaft trägt den veränderten Materialeigenschaften in dem jeweiligen beaufschlagten Bereich des Festkörpers 1 Rechnung. Der Laserstrahl 11 beaufschlagt in dem gezeigten Fall z.B. einen Bereich des Festkörpers 1, der eine veränderte Transmission aufweist, die z.B. aus einem Dotierfleck resultieren kann.

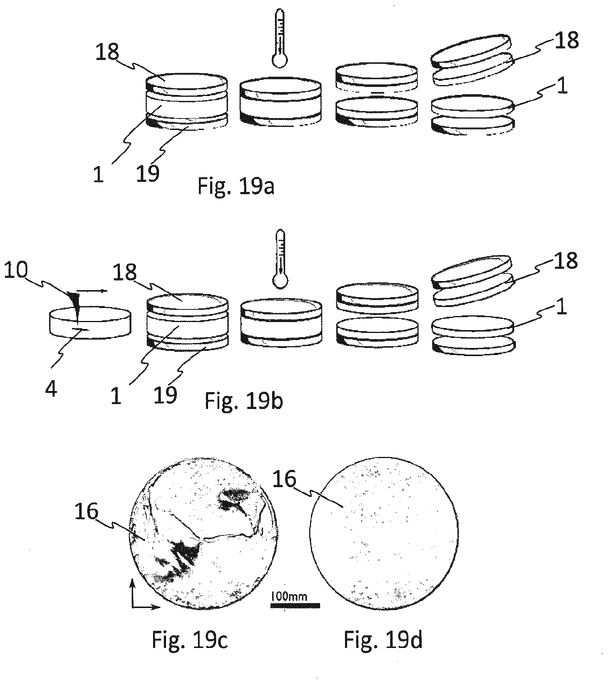

Bevorzugt erfolgt nach der Erzeugung der Modifikationen 2 das Abtrennen der Festkörperschicht 14 von dem Festkörper 1 gemäß der Darstellung von Fig. 19b.

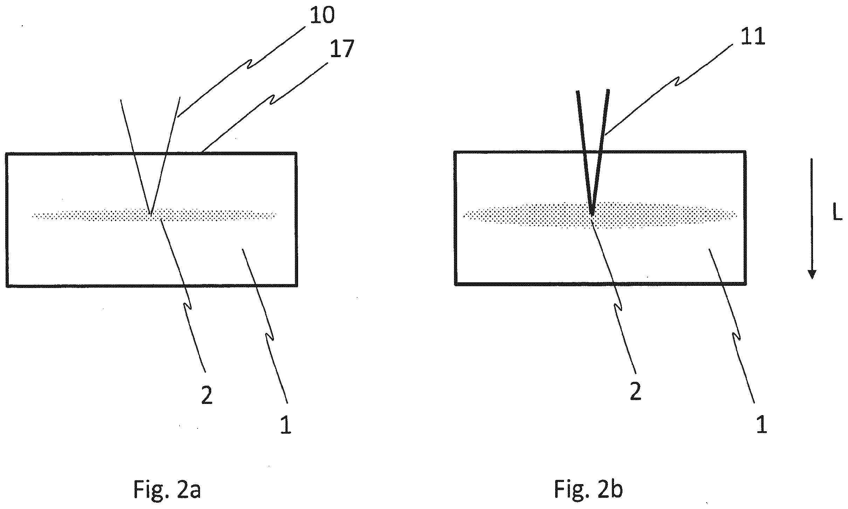

Fig. 2a zeigt eine Situation, in der Modifikationen 2 mit einer ersten Ausdehnung in Längsrichtung L des Festkörpers 1 erzeugt werden. Die Längsrichtung L erstreckt sich hierbei entsprechend der Erfindung orthogonal oder im Wesentlichen orthogonal zur Einstrahloberfläche 17 des Festkörpers 1, wobei die Einstrahloberfläche 17 des Festkörpers 1 nach dem Abtrennen der Festkörperschicht 14 Bestandteil der Festkörperschicht 14 ist. Dies trifft bevorzugt für alle in dieser Schrift beschriebenen Ausführungsformen zu. Die gemäß Fig. 2a erzeugten Modifikationen 2 sind zum Führen eines Risses zum Abtrennen der Festkörperschicht 14 ausreichend.

Fig. 2b zeigt eine Ausführungsform, gemäß der die erzeugten Modifikationen 2 eine gegenüber Fig. 2a größere Ausdehnung in Längsrichtung L aufweisen. Zusätzlich oder alternativ können mehrere, insbesondere zwei oder drei oder mehr als zwei oder drei, Schichten an Modifikationen 2 zumindest abschnittsweise erzeugt werden.

Dies ist vorteilhaft, da durch eine größer als nötige Ausdehnung der Laserschicht in Strahlrichtung (Tiefe bzw. Festkörperlänge) der Stress, den die Laserschicht im unmodifizierten Material erzeugt, erhöht werden kann. Somit kann bevorzugt mehr Material eine Phasenumwandlung durchmachen oder amorphisiert oder anderweitig modifiziert werden - als für den Polymersplit nötig (vgl. Fig. 19b). Dieser erhöhte Stress dient dazu, den Spontansplit des Materials (ohne Polymer) zu befördern. Die Laserparameter bzw. Laserstrahlparameter bzw. Parameter, mit denen die Laserbeaufschlagungseinrichtung konfiguriert wird - für den Spontansplit und den Polymerprozess - können sich dadurch erheblich unterscheiden, z.B. in benötigter numerischer Apertur und/oder Pulslänge und/oder Pulsenergie. Eine größere Ausdehnung der Laserschicht führt dabei zu einem höheren Druck im Festkörper, wodurch die Spontansplitwahrscheinlichkeit erhöht wird. Ferner ist diese Ausführungsform vorteilhaft, da eine Festkörperschicht 14 als gebogene bzw. gekrümmte Festkörperschicht 14 erzeugt werden kann. Somit lässt sich dieses Verfahren bevorzugt auch zum Erzeugen von mindestens einer zumindest abschnittsweise gewölbten oder gebogenen Festkörperschicht 14 verwenden. Zur Erzeugung einer gekrümmten oder gebogenen Festkörperschicht (bzw. gebogener oder gekrümmter Wafer) umfasst das Verfahren hierbei bevorzugt mindestens die Schritte: Bewegen des Festkörpers 1 relativ zu einer Laserbeaufschlagungseinrichtung 8, nacheinander Erzeugen von Laserstrahlen 10 mittels der Laserbeaufschlagungseinrichtung 8 zum Erzeugen von jeweils mindestens einer Modifikation 2 im Inneren des Festkörpers, wobei durch die Modifikationen 2 ein Rissführungsbereich 4 zum Führen eines Risses zum Abtrennen eines Festkörperanteils 6, insbesondere einer Festkörperschicht, von dem Festkörper 1 vorgegeben wird, wobei die Modifikationen einen Druckanstieg im Festkörper bewirken, wobei die Festkörperschicht 14 infolge des Druckanstiegs entlang des Rissführungsbereichs 4 durch eine Rissausbreitung vom Festkörper 1 abgetrennt wird, wobei zumindest ein Anteil der Modifikationen 2 als Bestandteil der Festkörperschicht 14 von dem Festkörper 1 abgetrennt wird, wobei die Festkörperschicht 14 aufgrund der Modifikationen 2 in eine gebogene oder gewölbte Form überführt wird, wobei der sich aus dem Rissführungsbereich 4 ergebende weitere Oberflächenanteil 16 der Festkörperschicht somit zumindest abschnittsweise konvex geformt ist.

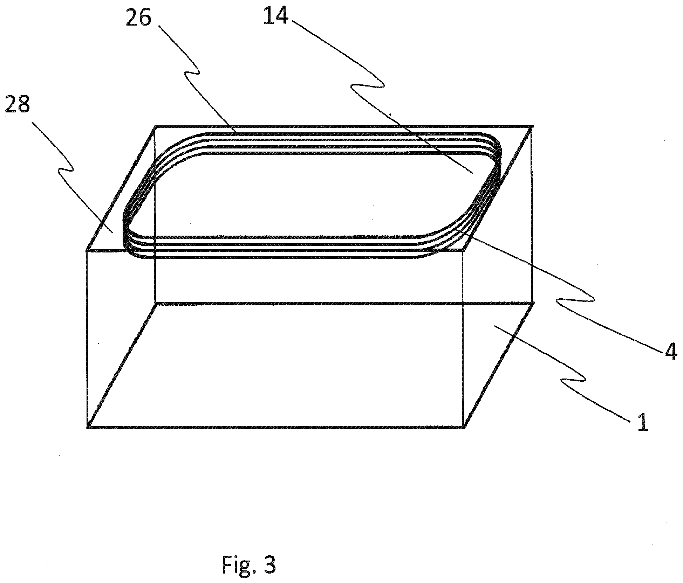

Fig. 3 zeigt eine Anordnung, nach der Erzeugung einer Rissführungsbereichs 4 im Festkörper 1 zumindest abschnittsweise und bevorzugt umlaufend ein Graben 26 ausgehend von der Einstrahloberfläche 17 in Längsrichtung L des Festkörpers 1 erzeugt wird. Nach der Erzeugung des Grabens 26 kann die Festkörperschicht 14 durch die Erzeugung weiterer Modifikationen 2 mittels Laserstrahlen 10, die bevorzugt ebenfalls über die Einstrahloberfläche 17 eingebracht werden, vom Festkörper abgetrennt werden. Alternativ wird bevorzugt eine Spannungserzeugungsschicht 18 zumindest auf dem vom Graben 26 umschlossenen bzw. umgebenen oder begrenzten Bereich, insbesondere auf der Oberfläche der späteren Festkörperschicht 14, angeordnet oder erzeugt.

Die Spannungserzeugungsschicht besteht bevorzugt aus einem Polymermaterial, insbesondere PDMS, und wird in einem weiteren Schritt bevorzugt zumindest abschnittsweise und besonders bevorzugt vollständig thermisch beaufschlagt, insbesondere abgekühlt, insbesondere unterhalb ihre Glasübergangstemperatur abgekühlt. Dies trifft bevorzugt für alle hierin beschriebenen Ausführungsformen zu, in denen eine Spannungserzeugungsschicht verwendet bzw. eingesetzt wird.

Infolge der Spannungserzeugung trennt ein Riss die Festkörperschicht 14 von dem verbleibenden Festkörper 1 ab.

Bevorzugt erfolgt in einem weiteren Schritt eine Oberflächenbehandlung des Festkörpers 1. Es wird bevorzugt der sich zwischen dem Graben 26 und der umlaufenden Oberfläche ergebende Rahmen 28 und/oder die durch das Abtrennen der Festkörperschicht 14 freigelegte Oberfläche des Festkörpers 1 geglättet, insbesondere abgeschliffen, geläppt, poliert oder geätzt. Bevorzugt werden der Rahmen 28 und die freigelegte Oberfläche derart, insbesondere spanend, behandelt, dass ihre Oberflächen in derselben Ebene liegen.

Es wird somit erfindungsgemäß ein Verfahren zum Abtrennen von mindestens einer Festkörperschicht bzw. Festkörperlage, insbesondere einer Festkörperscheibe, 14 von einem Festkörper bzw. Spendersubstrat 1 bereitgestellt, dass bevorzugt mindestens die nachfolgend genannten Schritte umfast: Bereitstellen eines Festkörpers 1, Erzeugen von Modifikationen 2 im Inneren des Festkörpers 1 mittels LASER-Strahlen 10, wobei durch die Modifikationen 2 ein Ablösebereich bzw. Rissführungsbereichs vorgegeben wird, entlang dem eine Abtrennung der Festkörperschicht 14 von dem Festkörper 1 erfolgt, Abtragen von Material am Rand des Festkörpers 1, insbesondere zum Erzeugen einer umlaufenden Vertiefung 12 wobei der Materialabtrag in Längsrichtung des Festkörpers erfolgt, wobei durch den Materialabtrag der Ablösebereich freigelegt wird, und Abtrennen der Festkörperschicht von dem Festkörper.

Dies ist vorteilhaft, da eine Laserbearbeitung bis zum Rand problematisch ist und somit die erzeugte Festkörperschicht 14 auch in ihrem Randbereich sehr homogene Eigenschaften aufweist. Das hiermit vorgestellte Grundkonzept umfasst somit eine Laserablation / Schliff / Materialentfernung von oben zum Erzeugen einer Kerbe oder eines Grabens, wodurch die zuvor erzeugte Laserschicht geöffnet bzw. freigelegt wird. Anschließend erfolgt ein Herausheben der Festkörperschicht 14 bzw. des Zielwafers mit der Spannungserzeugungsschicht 18. Der übergebliebene Rand bzw. Rahmen 28 kann dann während einer weiteren Oberflächenaufbereitung wieder weggeschliffen werden. Somit kann per Ablation von oben, insbesondere per Wasserstrahlschneiden oder Laserablation, die Laserschicht freigelegt und Randeffekte beim Polymersplit vermieden werden.

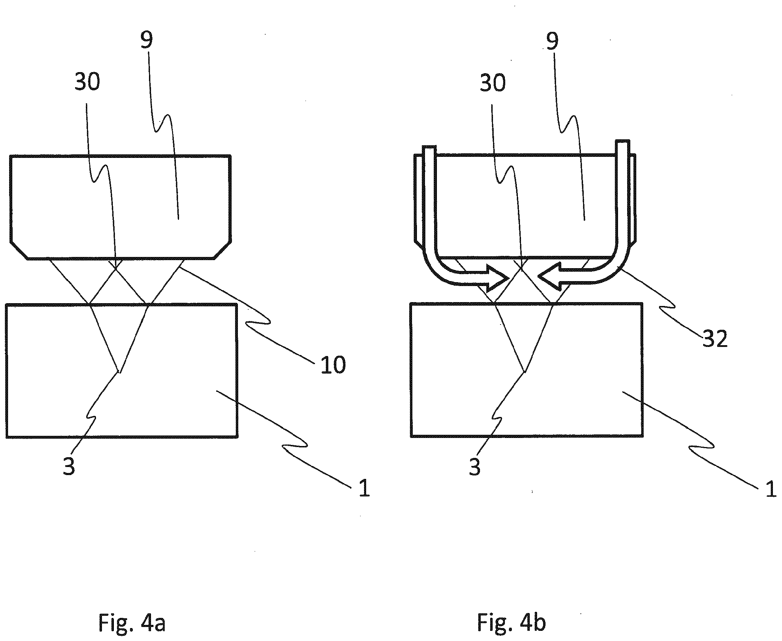

Fig. 4a zeigt eine Anordnung, bei der sich Partikel, wie z.B. Staub, an dem mit dem Bezugszeichen 30 gekennzeichneten Kreuzungspunkt der reflektierten Strahlung, ansammeln und somit die Modifikationserzeugung negativ beeinflussen.

Fig. 4b zeigt eine Anordnung, bei der eine Spüleinrichtung 32 bzw. Spülung vorgesehen ist. Es wird somit bevorzugt ein Fluid, insbesondere ein Gas und bevorzugt ein ionisiertes Gas, dem Kreuzungspunkt 30 zugeleitet, um die sich in dem Kreuzungspunkt 30 ansammelnden Partikel mittels der Fluidströmung wegzuspülen.

Somit wird ein Verfahren zum Abtrennen von mindestens einer Festkörperschicht bzw. Festkörperlage, insbesondere einer Festkörperscheibe, 14 von einem Festkörper bzw. Spendersubstrat 2 bereitgestellt, dass bevorzugt mindestens die nachfolgend angeführte Schritte umfasst: Bereitstellen eines Festkörpers 1, Einstellen eines Strömungsverhaltens eines sich zwischen dem Festkörper und der Laserbeaufschlagungseinrichtung 8, insbesondere im Bereich des Strahlungsverlaufs, befindlichen Gases, insbesondere Luft, zur Verhinderung von Staubansammlungen im Bereich des Laserstrahlung, Erzeugen von Modifikationen 2 im Inneren des Festkörpers 1 mittels LASER-Strahlen 10 einer Laserbeaufschlagungseinrichtung 8, wobei durch die Modifikationen 2 ein Ablösebereich bzw. Rissführungsbereichs vorgegeben wird, entlang dem eine Abtrennung der Festkörperschicht 14 von dem Festkörper 1 erfolgt und Abtrennen der Festkörperschicht von dem Festkörper. Diese Lösung ist vorteilhaft, da hohe Laserintensitäten Staub statisch aufladen und dieser Staub durch die Spülung, insbesondere mit ionisiertem Gas, aus dem Bereich zwischen dem Objektiv und dem Werkstück herausgespült werden kann. Die Gasspülung treibt somit den Staub raus aus dem Zwischenraum zwischen dem Objektiv 9 der Laserbeaufschlagungseinrichtung 8 und dem Werkstück bzw. Festkörper 1. Zusätzlich oder alternativ kann der Fluidstrom, insbesondere der Gasstrom, zum Erzeugen einer Kühlwirkung gegen absorbierte Leistung durch das Objektiv geleitet werden. Somit ist das Objektiv bevorzugt zum Leiten eines Fluids, insbesondere des Spülfluids, ausgebildet.

Weiterhin bzw. zusätzlich kann eine Kompensation von sphärischen Aberrationen am Objektiv erfolgen. Dies verändert den Fokus an der Oberfläche (Einbeziehung des durchlaufenen Materials mit anderem Brechindex), wodurch sich der Fokus in Luft verschlechtert und dadurch eine geringere Intensität aufweist, was wiederum zu einer geringeren Partikelansaugwirkung bzw. Staubsaugerwirkung führt. Zusätzlich oder alternativ können verringerte Reflexion an der Oberfläche bewirkt werden. Dies kann z.B. durch den Auftrag bestimmter Schichten bzw. Beschichtungen, insbesondere durch Spin-Coating, und/oder durch Brewster-Einstrahlung mit polarisiertem Licht bewirkt werden.

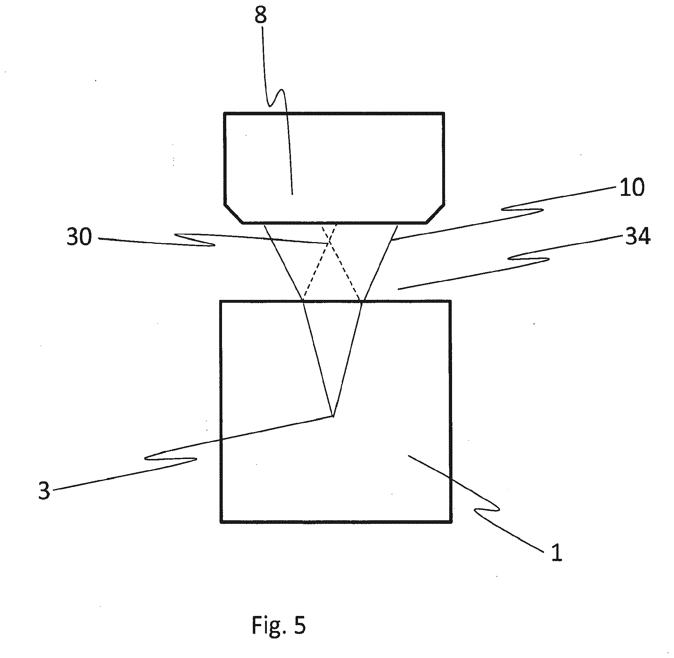

Fig. 5 zeigt eine schematische Anordnung, gemäß welcher der Festkörper 1 mit mindestens einer Beschichtung 34 versehen ist. Die Beschichtung 34 kann hierbei ein oder mehrschichtig sein. Bevorzugt weist die Beschichtung einen Brechzahlunterschied zur Brechzahl des Materials des Festkörpers 1 auf, insbesondere ist die Brechzahl des Materials des Festkörpers 1 bevorzugt höher als die der Beschichtung 34. Es ist ebenfalls denkbar, dass die Beschichtung 34 aus mehreren Schichten aufgebaut ist, wobei bevorzugt zumindest zwei der mehreren Schichten einen Brechzahlunterschied aufweisen. Bevorzugt ist dabei die Brechzahl der jeweiligen Schicht, die am nächsten zum Festkörper 1 angeordnet ist größer als die Brechzahl einer Schicht die zum Festkörper 1 weiter beabstandet ist.

Dieser schematische Aufbau ermöglicht somit erfindungsgemäß ein Verfahren zum Abtrennen von mindestens einer Festkörperschicht bzw. Festkörperlage, insbesondere einer Festkörperscheibe, 14 von einem Festkörper bzw. Spendersubstrat 1 bereitzustellen. Bevorzugt umfasst dieses Verfahren hierbei mindestens die nachfolgend genannten Schritte: Bereitstellen eines Festkörpers 1, wobei der Festkörper 1 mindestens eine Beschichtung 34 aufweist, deren Brechzahl zu der Brechzahl der Oberfläche des Festkörpers 1, an welcher die Beschichtung 34 angeordnet ist, verschieden ist, oder wobei an dem Festkörper 1 eine Beschichtung 34 erzeugt wird, deren Brechzahl zu der Brechzahl der Oberfläche des Festkörpers 1, an welcher die Beschichtung 34 angeordnet ist, verschieden ist, Erzeugen von Modifikationen 2 im Inneren des Festkörpers 1 mittels LASER-Strahlen 10 einer Laserbeaufschlagungseinrichtung 8, wobei durch die Modifikationen 2 ein Rissführungsbereichs 4 (vgl. analog Fig. 1) vorgegeben wird, entlang dem eine Abtrennung der Festkörperschicht 14 von dem Festkörper 1 erfolgt.

Die Erzeugung der Beschichtung kann z.B. mittels Spinn-Coating erfolgen. So bringt z.B. ein Lösungsmittel, versetzt mit Nanopartikeln von Materialien mit hohem Brechindex eine oder mehrere dünne (sub-Wellenlänge) Schichten mit etwas höherem Brechindex auf den Festkörper 1 bzw. das Werkstück 1 auf - dadurch entsteht eine Zwischenfläche mit reduziertem Brechzahlunterschied geringere Reflexion an der Oberfläche geringere Verschmutzung, mehr Leistung im Material für effizientere Materialbearbeitung. Spin-Coating ist vorteilhaft, da es schnell und günstig billig und schnell, mögliche Nanopartikel sind neben anderen oder zusätzlich zu anderen z.B. Silizium (n=3.55), Siliziumcarbid (n=2.6), Titanoxid (n=1.8), Glas (n=1.5), Al2O3 (n=1.72). Im Falle mehrerer Schichten, mit graduell ansteigendem Brechindex für noch effizientere Brechindexanpassung und Antireflexwirkung ist ein Mehrschichtprozess denkbar. Rein beispielhaft könnte dann eine Schichtanordnung erzeugt werden die aus den nachfolgend genannten Schichten bzw. Lagen besteht: 1. Schicht: Si, 2. Schicht: SiC, 3. Schicht: TiO2, jede Schicht bevorzugt 50-400 Nanometer dick. Dieses Verfahren ist ferner vorteilhaft, da mittels Spin-Coating von solchen Schichten außerdem kleinste Rauhigkeiten an der Materialoberfläche ausgeglichen werden können (bessere Materialeinkopplung, durch weniger Streuung an der Grenzfläche, bessere Wellenfront-Überlappung im Fokus in der Tiefe und somit wird eine niedrigere Laserleistung benötigt, dies führt zu einer effizienteren Bearbeitung, da sich eine höhere Multiphotonenübergangswahrscheinlichkeit ergibt. Die Spin-Coating-Schicht bzw. die Erzeugung einer Beschichtung 34 kann im Rahmen des Schrittes zur Oberflächenkonditionierung und Wiederaufbereitung der Oberfläche am Ingot bzw. Festkörper 1 nach erfolgtem Split bzw. Abtrennung der Festkörperschicht 14 aufgebracht werden. Es kann also zuerst ein Schleif-/Läpp-/Ätz- oder Polierschritt erfolgen und im Anschluss oder in Kombination mit einem der vorangegangenen Schritte der Spin-Coating-Schritt bzw. der Beschichtungsschritt, der die dünne Schicht bzw. Beschichtung 34 aufbringt.

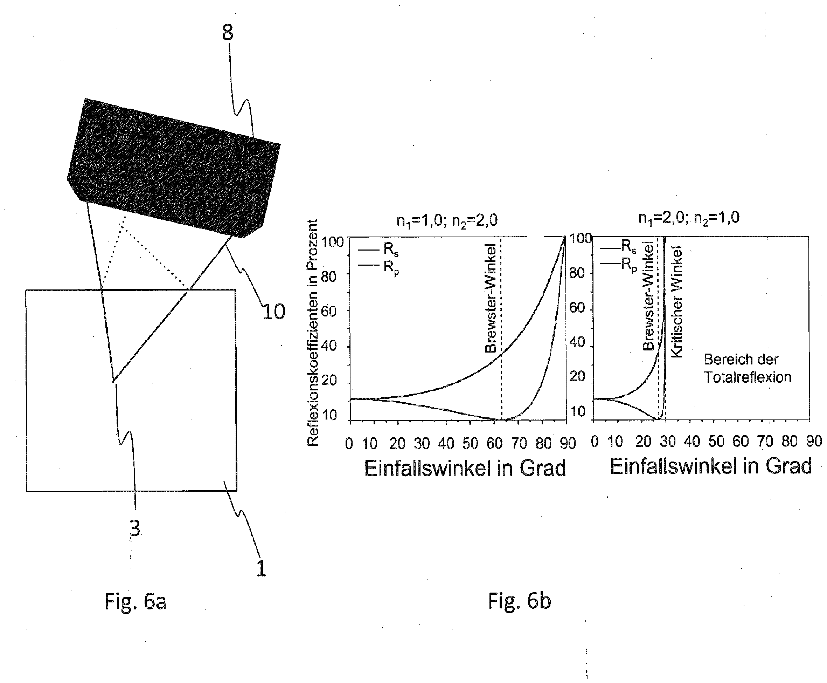

Fig. 6 zeigt schematisch eine Anordnung zur Einkoppelung von Laserstrahlen 10, wobei bei dieser Anordnung die Reflexion reduziert wird. Bevorzugt werden die Laserstrahlen 10 im Brewster-Winkel eingekoppelt. Der Brewster-Winkel ist ein Einstrahlwinkel für Licht einer bestimmten Polarisation (E-Vektor zeigt ins Material, nicht entlang der Oberfläche), bei dem keine Reflexion auftritt. Die Voraussetzungen hierfür sind, dass das Licht unter einem Winkel abhängig vom Brechzahlunterschied Luft/Material eingestrahlt wird. Ferner muss das Licht polarisiert sein (bei Laserlicht üblicherweise gegeben, erfordert Einzelmodenlaser und keine Photonic Crystal Fibers). Die Brewster-Winkel-Einkopplung dient somit zur Minimierung von Rückreflexionen. Wenn im Brewster-Winkel eingestrahlt wird, lässt sich die 30% Oberflächenreflexion nahezu vollständig für Materialbearbeitung in der Tiefe des Materials nutzen.

Eine Einstrahlung unter dem Brewster-Winkel ist kompliziert, da die unterschiedlichen Strahlanteile unterschiedlich lange Wege im hochbrechenderen Medium zurücklegen. Der Fokus muss dementsprechend durch höhere Energie angepasst werden und/oder durch Strahlformung. Die Strahlformung erfolgt hierbei bevorzugt z.B. über ein oder mehrere diffraktive optische Element/e (DOE), was diesen Unterschied abhängig über das Laserstrahlprofil ausgleicht. Der Brewster-Winkel ist relativ groß, was bei hoher numerischer Apertur Anforderungen an die Optik und deren Maße sowie Arbeitsabstand stellt. Dennoch ist diese Lösung vorteilhaft, da reduzierte Reflexionen an der Oberfläche auch zu reduzierter Oberflächenschädigung beitragen, da die Lichtintensität besser ins Material hineinkoppelt. Im Sinne dieser Erfindung können Laserstrahlen 10 auch in allen anderen in dieser Schrift offenbarten Ausführungsformen im Brewster-Winkel oder im Wesentlichen im Brewster-Winkel eingestrahlt werden. Zur Brewster-Winkel-Einkopplung wird hiermit auf das Dokument "Optical Properties of Spin-Coated TiO2 Antireflection Films on Textured Single-Crystalline Silicon Substrates" (Hindawi Publishing Corporation International Journal of Photoenergy, Volume 2015, Article ID 147836, 8 pages, http://dx.doi.org/10.1155/2015/147836) verwiesen. Dieses Dokument wird durch Bezugnahme vollumfänglich zum Gegenstand der vorliegenden Patentanmeldung gemacht. Das zuvor genannte und einbezogene Dokument offenbart insbesondere Berechnungen zum optimalen Einstrahlwinkel für verschiedene Materialien und damit Brechindizes. Die Energie des Lasers bzw. der Laserbeaufschlagungseinrichtung 8 wird nicht so sehr in Abhängigkeit vom Material, sondern eher von der möglichen Transmission unter einem bestimmten Winkel angepasst. Wenn also die optimale Transmission z.B. 93% beträgt, so müssen diese Verluste gegenüber Versuchen mit senkrechter Einstrahlung und Verlusten von z.B. dann 17% berücksichtigt werden und die Laserleistung dementsprechend angepasst werden.

Ein Beispiel: 83% Transmission senkrecht gegenüber 93% unter Winkel, bedeutet, dass zum Erzielen der gleichen Energie in der Tiefe, nur noch 89% der bei senkrechter Einstrahlung verwendeten Laserleistung benötigt werden (0.83/0.93=0.89). Im Sinne der Erfindung dient der Teil der schrägen Einstrahlung also bevorzugt dazu weniger Licht durch Oberflächenreflexion zu verlieren und mehr in die Tiefe zu bringen. Ein mögliches nachgelagertes Problem, das dadurch in bestimmten Konstellationen auftreten kann, ist, dass der Fokus in der Tiefe ein "schiefes" Profil erhalten kann und damit die erreichten Intensitäten - die Schlüsselgröße für Multiphotonenbearbeitung - wieder geringer sind, eventuell also sogar geringer als bei senkrechter Einstrahlung, wo alle Strahlanteile denselben optischen Weg im Material durchlaufen. Dies kann dann bevorzugt durch ein diffraktives optisches Element oder durch mehrere diffraktive Elemente oder einen durchlaufenden Keil oder mehrere durchlaufende Keile - und/oder andere optische Elemente - im Strahlengang geschehen, die diese zusätzlichen Wege und/oder den Einfluss auf die einzelnen Strahlen - insbesondere unterschiedliche sphärische Aberrationen über das Strahlprofil hin - kompensieren. Diese DOEs kann man numerisch mit geeigneten Softwarelösungen (z.B. Virtuallab von Lighttrans, Jena) berechnen und dann fertigen bzw. bereitstellen.

Somit stellt die vorliegende Erfindung ein Verfahren zum Abtrennen von mindestens einer Festkörperschicht bzw. Festkörperlage, insbesondere einer Festkörperscheibe, 14 von einem Festkörper bzw. Spendersubstrat 1 bereit. Das erfindungsgemäße Verfahren umfasst hierbei bevorzugt mindestens die Schritte: Bereitstellen eines Festkörpers 1, Erzeugen von Modifikationen 2 im Inneren des Festkörpers 1 mittels LASER-Strahlen 10 einer Laserbeaufschlagungseinrichtung 8, wobei durch die Modifikationen 10 ein Rissführungsbereichs vorgegeben wird, entlang dem eine Abtrennung der Festkörperschicht 14 von dem Festkörper 1 erfolgt, wobei die Laserstrahlung im Brewster-Winkel oder mit einer Abweichung im Bereich von -10° bis +10° vom Brewster-Winkel auf den Festkörper 1 einstrahlt. Weiterhin umfasst das Verfahren bevorzugt den Schritt des Abtrennens der Festkörperschicht 14 von dem Festkörper 1.

Es wurde somit im Rahmen der vorliegenden Erfindung erkannt, dass ein hoher Brechzahlunterschied zwischen Luft/Material Leistungsverluste bis 30% bei senkrechter Einstrahlung bedeutet. Bei 100W-Laser sind also 30W für die Materialbearbeitung nicht verfügbar oder haben andere Effekte. So wurde z.B. ferner erkannt, dass Verschmutzungen an der Optik, wie bei sog. "opt. Pinzetten", entstehen können. Dabei wandern kleinste Staubteilchen sowohl in Luft als auch in Flüssigkeiten bei hohen Laserintensitäten immer zum Fokus des Laserstrahls (höchste Intensität) - reflektierte Leistung an der Oberfläche hat Fokus in der Luft oder in der Nähe der Optik, der Staub wird zur Optik getrieben/gezogen. Ferner wurde erkannt, dass gleichzeitig bei 100W Laserleistung und 97% Transmission am Objektiv auch signifikant Wärme (3W) ins Objektiv gelangen kann, die abgeführt/kompensiert werden muss, um thermische Schäden/Veränderungen des Prozesses zu vermeiden. Weiter wurde erkannt, dass hohe Leistungen die Gefahr der Oberflächenschädigung mit sich bringen. Denn die Absorption des Materials kann aufgrund von Oberflächenzuständen an der Oberfläche erhöht sein, kleinste Staubpartikel können daher im Laserstrahl 10 erst verbrennen und dann Absorptionskeime bilden, was zu weiterer Schädigungen durch Absorption führen kann. Ferner wurde erkannt, dass hohe Leistungen mit diffraktiven optischen Elementen (DOEs) auf mehrere Foki in der Brennebene aufgeteilt werden. DOEs zeigen Interferenzerscheinungen schon vor der Brennebene, es wurde erkannt, dass Interferenzen an der Oberfläche, vor der Brennebene lokale Intensitätsmaxima erzeugen können, die zur Schädigung der Oberfläche führen können und zu einer verringerten Transmissivität für Laserstrahlung zur Bearbeitung in der Tiefe führen können. Weiterhin wurde erkannt, dass manche Materialien (Bsp: SiC) lokale Brechindex- und andere Materialeigenschaftsunterschiede (z.B. Absorption, Transmission, Streuung), z.B. durch die Materialdotierung (häufiges Auftreten: Dotierfleck) haben. Ferner wurde erkannt, dass abhängig von der Oberflächenrauhigkeit des Materials an der Lasereinkoppeloberfläche die Wellenfront des Lasers in der Tiefe des Materials signifikant beeinträchtigt werden kann, sodass der Fokus reduzierte Intensität aufweist (geringere Multiphotonenübergangswahrscheinlichkeit), was wieder höhere Intensitäten mit oben genannten Problemen nach sich ziehen würde.

Einzelne, mehrere oder alle dieser Probleme lassen sich durch einzelne oder Kombinationen der hier offenbarten Verfahren behandeln. Somit kann die vorliegende Erfindung bevorzugt als ein Verfahren zum Abtrennen von mindestens einer Festkörperschicht von einem Festkörper verstanden werden. Wobei bei diesem Verfahren durch die Modifikationen 2 bevorzugt ein Rissführungsbereich 4 zum Führen eines Risses zum Abtrennen eines Festkörperanteils 6, insbesondere einer Festkörperschicht, von dem Festkörper 1 vorgegeben wird. Das erfindungsgemäße Verfahren umfasst dabei bevorzugt mindestens die Schritte: Bewegen des Festkörpers 1 relativ zu einer Laserbeaufschlagungseinrichtung 8, nacheinander Erzeugen von Laserstrahlen 10 mittels der Laserbeaufschlagungseinrichtung 8 zum Erzeugen von jeweils mindestens einer Modifikation 2, Abtrennen der Festkörperschicht von dem Festkörper.

Erfindungsgemäß wird somit ein Spalling-Prozess beschrieben, der insbesondere für großflächige Halbleitersubstrate mit bis zu 300mm oder mit mehr als 300mm Durchmesser günstig skaliert. Um die Wallner-Linienmuster zu beseitigen, wird ein Laser-Konditionierungsprozess, insbesondere mit hoher numerischer Apertur, bei Photonenenergien bevorzugt unterhalb der Materialbandlückenenergie verwendet. Dieser Prozess führt zu Mehrphotonenwechselwirkungen im Material, und liefert nach dem Spalling-Prozess eine Oberflächenrauhigkeit von bevorzugt Ra <1 μm.

Bevorzugt sind einzelne oder mehrere der zuvor genannten erfindungsgemäßen Lösungen miteinander kombinierbar, da dadurch eine noch bessere Festkörperschichtenherstellung bzw. Festkörperschichtenabtrennung bewirkt werden kann. So wird gemäß dem erfindungsgemäßen Verfahren die Laserbeaufschlagungseinrichtung 8 zur definierten Modifikationserzeugung in Abhängigkeit von zumindest einem Parameter nämlich der Transmission des Festkörpers an definierten Stellen und für eine definierte Festkörpertiefe eingestellt und/oder die Modifikationen bewirken einen Druckanstieg im Festkörper, wobei die Festkörperschicht infolge des Druckanstiegs entlang des Rissführungsbereichs durch eine Rissausbreitung vom Festkörper abgetrennt wird, wobei bevorzugt zumindest ein Anteil der Modifikationen als Bestandteil der Festkörperschicht von dem Festkörper abgetrennt wird und wobei die Festkörperschicht bevorzugt aufgrund der Modifikationen in eine gebogene oder gewölbte Form überführt wird, wobei der sich aus dem Rissführungsbereich ergebende weitere Oberflächenanteil der Festkörperschicht somit zumindest abschnittsweise konvex geformt ist und/oder der Festkörper weist mindestens eine Beschichtung auf, deren Brechzahl zu der Brechzahl der Oberfläche des Festkörpers, an welcher die Beschichtung angeordnet ist, verschieden ist, oder an dem Festkörper wird eine Beschichtung erzeugt, deren Brechzahl zu der Brechzahl der Oberfläche des Festkörpers, an welcher die Beschichtung angeordnet ist, verschieden ist, und/oder die Laserstrahlung strahlen im Brewster-Winkel oder mit einer Abweichung im Bereich von -5° bis +5°, insbesondere mit einer Abweichung im Bereich von -4° bis +4° oder mit einer Abweichung im Bereich von -3° bis +3° oder mit einer Abweichung im Bereich von -2° bis +2° oder mit einer Abweichung im Bereich von -1° bis +1°vom Brewster-Winkel auf den Festkörper ein, und/oder das Verfahren umfasst zusätzlich oder alternativ einen oder mehrere der Schritte: Abtragen von Material des Festkörpers 1, insbesondere zum Erzeugen einer umlaufenden Vertiefung 12, wobei der Materialabtrag in Längsrichtung des Festkörpers erfolgt, wobei durch den Materialabtrag der Rissführungsbereich freigelegt wird, oder Einstellen eines Strömungsverhaltens eines sich zwischen dem Festkörper und der Laserbeaufschlagungseinrichtung 8, insbesondere im Bereich des Strahlungsverlaufs, befindlichen Gases, insbesondere Luft, zur Verhinderung von Staubansammlungen im Bereich des Laserstrahlung.

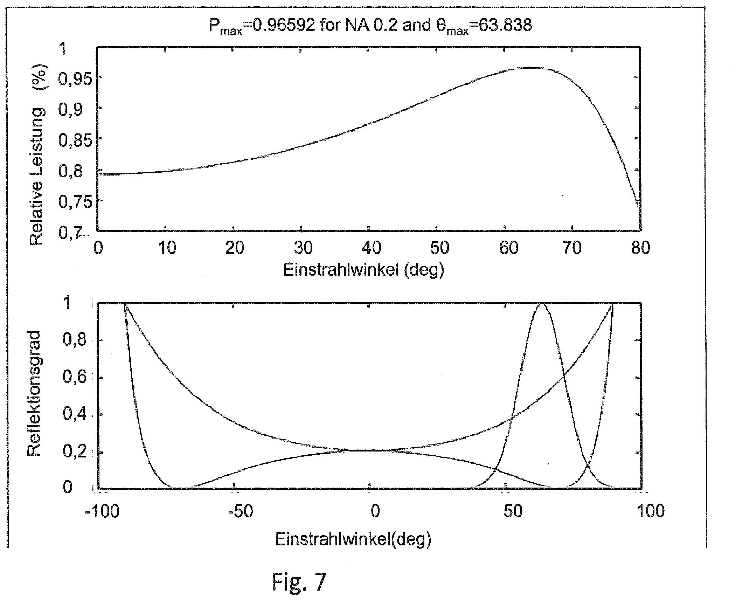

Die Figuren 7-18 zeigen Beispiele für die Berechnung des optimalen Einstrahlwinkels für ein 1/e2 Gauss-Profil und verschiedene numerische Aperturen unter Berücksichtigung der Brechzahlabhängigkeit der Oberflächenreflexion.

Die Figuren 7-10 zeigen die Verläufe beim Einsatz von Siliziumkarbid (n=2.7)

Ziel: Maximierung der in die Probe eingekoppelten Laserleistung, idealerweise durch Ausnutzung des Brewsterwinkels für minimale Oberflächenreflexion bei p-polarisiertem Licht. Ergebnis: Für eine NA=0.8 lohnt eine Brewster-Einkopplung nicht (Strahlkegel koppelt außen schon fast unter Brewster ein), kleinere NA können davon profitieren, insbesondere NA=0.2, höhere NA haben einen dazwischenliegenden Idealwinkel.

Fig. 7 zeigt in der oberen Abbildung: relative eingekoppelte Leistung über Einstrahlwinkel für Gaussprofil und in der untere Abbildung: Reflexionskoeffizient für p-(rot) und s-(blau)polarisiertes Licht und Winkel-Gauss-Profil für abgebildete NA=0.2 (grün), optimaler Einstrahlwinkel hier 63.8°.

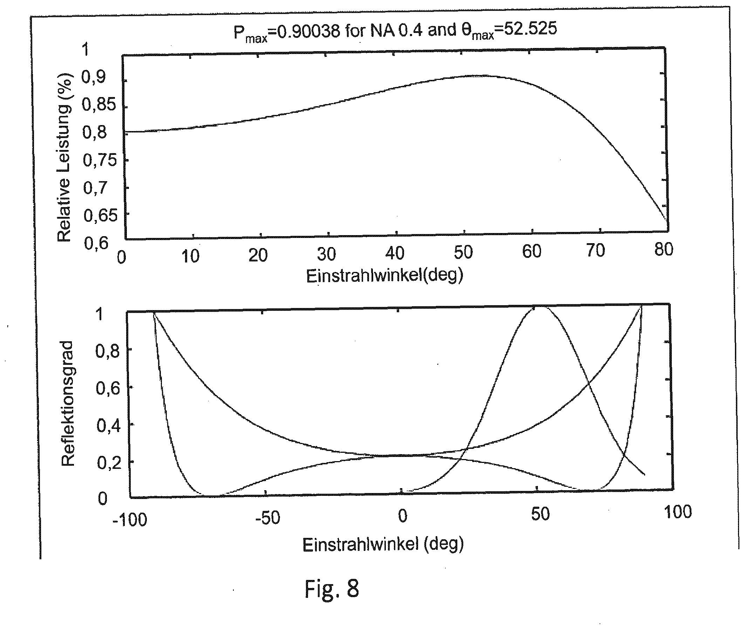

Fig. 8 zeigt in der oberen Abbildung: relative eingekoppelte Leistung über Einstrahlwinkel für Gaussprofil und in der untere Abbildung: Reflexionskoeffizient für p-(rot) und s-(blau)polarisiertes Licht und Winkel-Gauss-Profil für abgebildete NA=0.4 (grün), optimaler Einstrahlwinkel hier 52.5°.

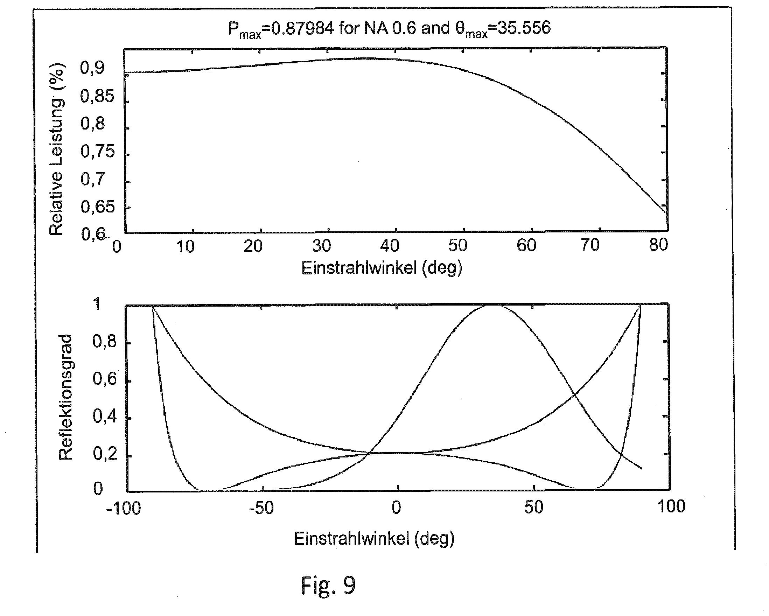

Fig. 9 zeigt in der oberen Abbildung: relative eingekoppelte Leistung über Einstrahlwinkel für Gaussprofil und in der untere Abbildung: Reflexionskoeffizient für p-(rot) und s-(blau)polarisiertes Licht und Winkel-Gauss-Profil für abgebildete NA=0.6 (grün), optimaler Einstrahlwinkel hier 35.6°.

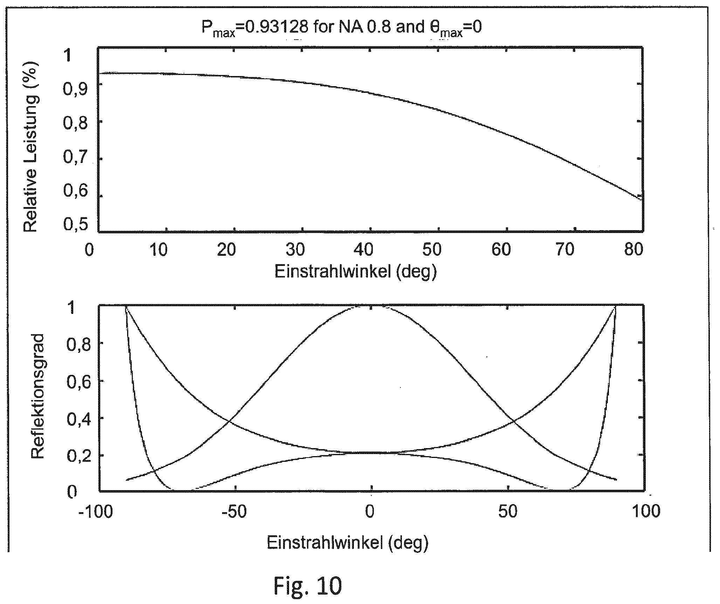

Fig. 10 zeigt in der oberen Abbildung: relative eingekoppelte Leistung über Einstrahlwinkel für Gaussprofil und in der untere Abbildung: Reflexionskoeffizient für p-(rot) und s-(blau)polarisiertes Licht und Winkel-Gauss-Profil für abgebildete NA=0.8 (grün), optimaler Einstrahlwinkel hier 0°.

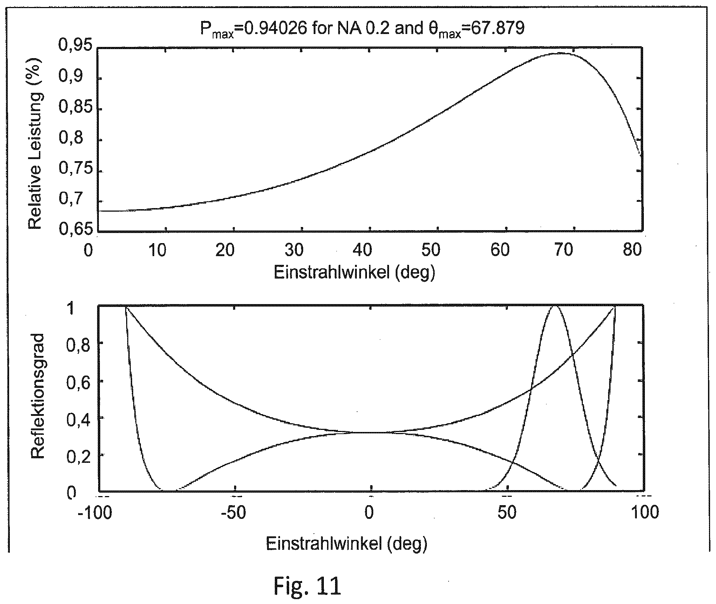

Die Figuren 11-14 zeigen die Verläufe beim Einsatz von Silizium (n=3.6).

Das hier angestrebte Ziel ist die Maximierung der in die Probe eingekoppelten Laserleistung, idealerweise durch Ausnutzung des Brewster-Winkels für minimale Oberflächenreflexion bei p-polarisiertem Licht. Das Ergebnis: Für eine NA=0.8 lohnt eine Brewster-Einkopplung nicht (Strahlkegel koppelt außen schon fast unter Brewster ein), kleinere NA können davon profitieren, insbesondere NA=0.2, höhere NA haben einen dazwischenliegenden Idealwinkel.

Fig. 11 zeigt in der oberen Abbildung: relative eingekoppelte Leistung über Einstrahlwinkel für Gaussprofil für Silizium und in der untere Abbildung: Reflexionskoeffizient für p-(rot) und s-(blau)polarisiertes Licht und Winkel-Gauss-Profil für abgebildete NA=0.2 (grün), optimaler Einstrahlwinkel hier 67.9°.

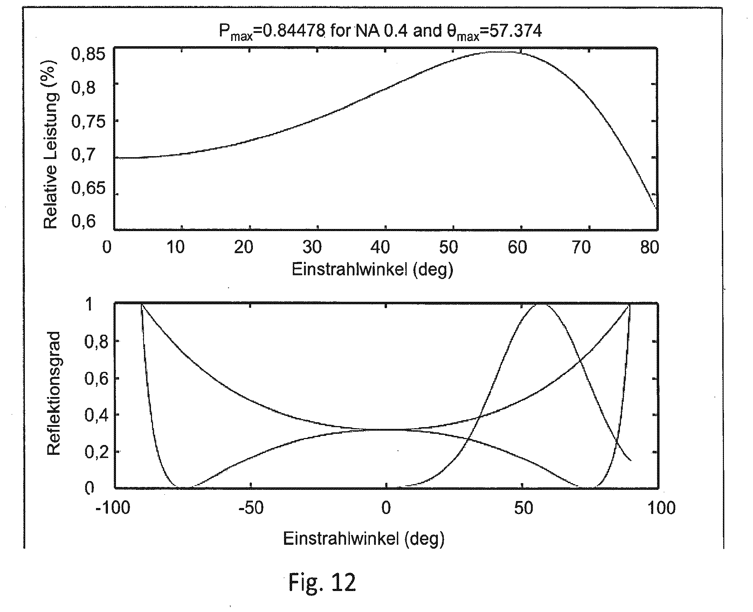

Fig. 12 zeigt in der obere Abbildung: relative eingekoppelte Leistung über Einstrahlwinkel für Gaussprofil für Silizium und in der untere Abbildung: Reflexionskoeffizient für p-(rot) und s-(blau)polarisiertes Licht und Winkel-Gauss-Profil für abgebildete NA=0.4 (grün), optimaler Einstrahlwinkel hier 57.4°.

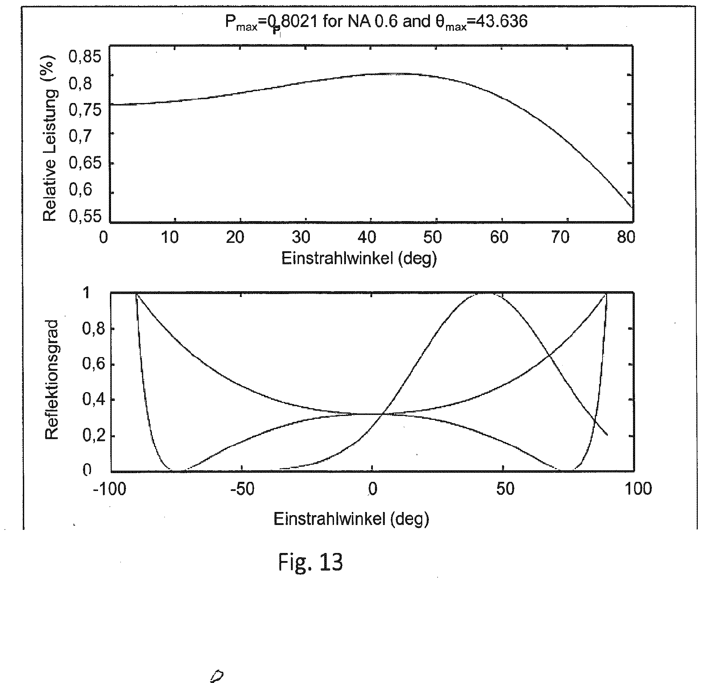

Fig. 13 zeigt in der oberen Abbildung: relative eingekoppelte Leistung über Einstrahlwinkel für Gaussprofil für Silizium und in der untere Abbildung: Reflexionskoeffizient für p-(rot) und s-(blau)polarisiertes Licht und Winkel-Gauss-Profil für abgebildete NA=0.6 (grün), optimaler Einstrahlwinkel hier 43.6°.

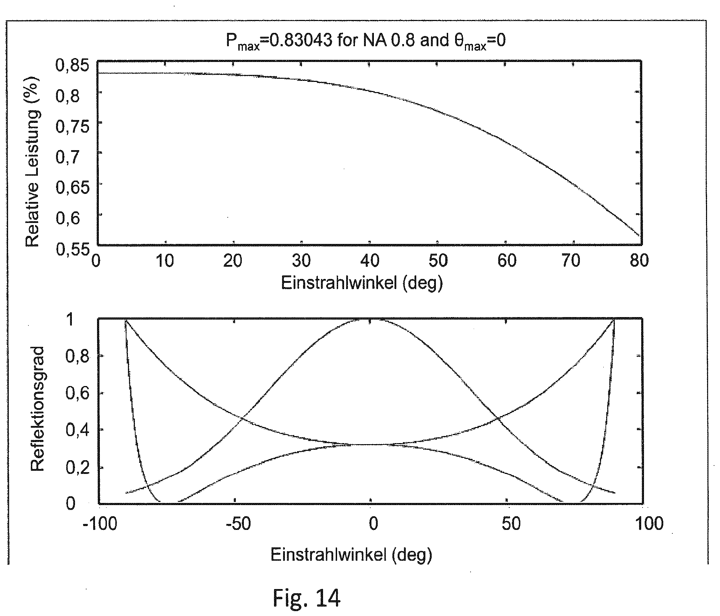

Fig. 14 zeigt in der oberen Abbildung: relative eingekoppelte Leistung über Einstrahlwinkel für Gaussprofil für Silizium und in der untere Abbildung: Reflexionskoeffizient für p-(rot) und s-(blau)polarisiertes Licht und Winkel-Gauss-Profil für abgebildete NA=0.8 (grün), optimaler Einstrahlwinkel hier 0°.

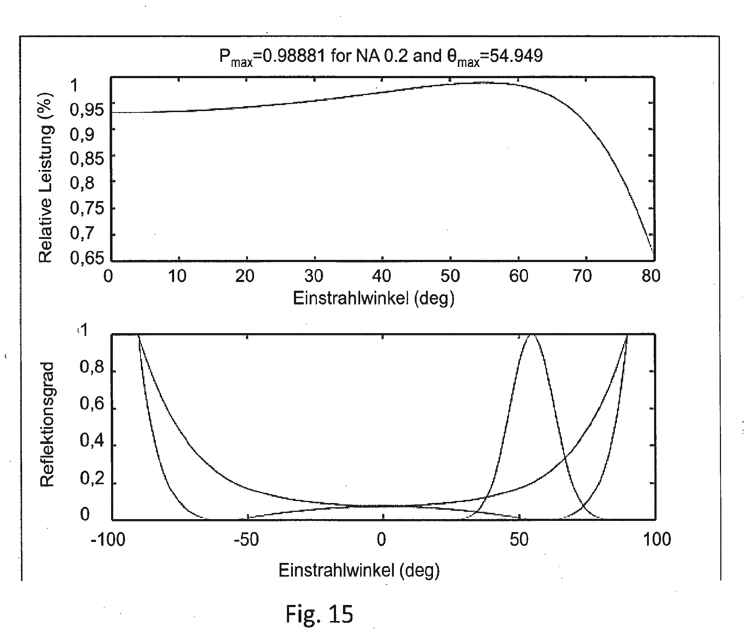

Die Figuren 15-18 zeigen die Verläufe beim Einsatz von Saphir/ALO (n=1.72)

Das hier angestrebte Ziel ist die Maximierung der in die Probe eingekoppelten Laserleistung, idealerweise durch Ausnutzung des Brewsterwinkels für minimale Oberflächenreflexion bei p-polarisiertem Licht. Das Ergebnis: Für eine NA=0.8 lohnt eine Brewster-Einkopplung nicht (Strahlkegel koppelt außen schon fast unter Brewster ein), kleinere NA können davon profitieren, insbesondere NA=0.2, höhere NA haben einen dazwischenliegenden Idealwinkel, wobei NA=0.6 fast keinen Winkel zur Einstrahlung benötigt.

Fig. 15 zeigt in der oberen Abbildung: relative eingekoppelte Leistung über Einstrahlwinkel für Gaussprofil für ALO und in der untere Abbildung: Reflexionskoeffizient für p-(rot) und s-(blau)polarisiertes Licht und Winkel-Gauss-Profil für abgebildete NA=0.2 (grün), optimaler Einstrahlwinkel hier 54.9°.

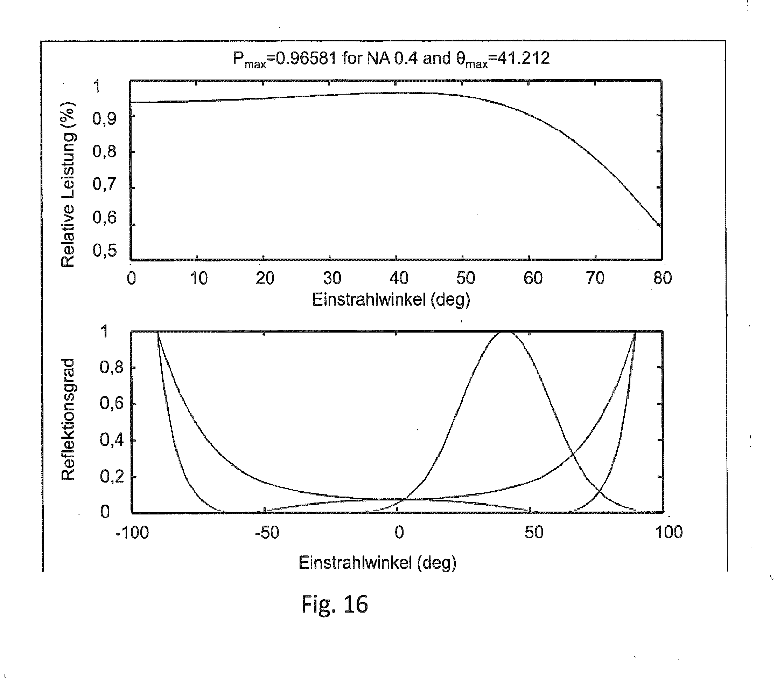

Fig. 16 zeigt in der oberen Abbildung: relative eingekoppelte Leistung über Einstrahlwinkel für Gaussprofil für ALO und in der untere Abbildung: Reflexionskoeffizient für p-(rot) und s-(blau)polarisiertes Licht und Winkel-Gauss-Profil für abgebildete NA=0.4 (grün), optimaler Einstrahlwinkel hier 41.2°.

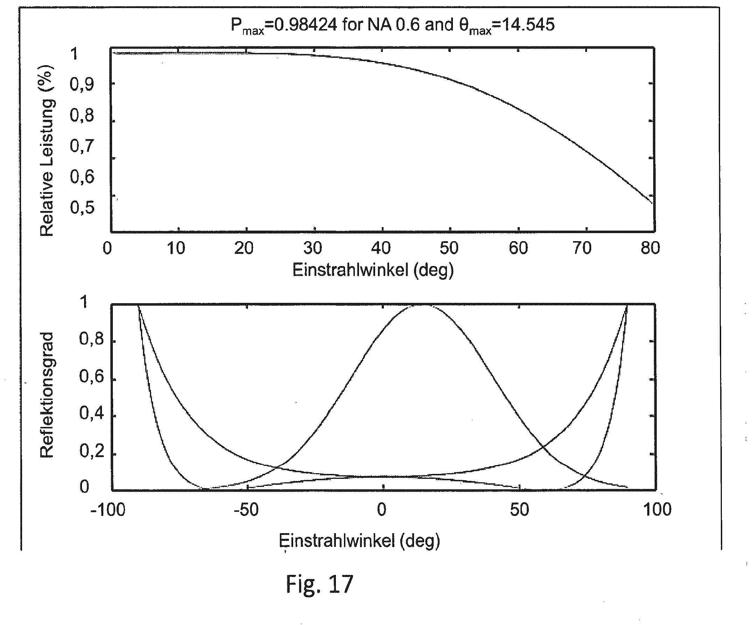

Fig. 17 zeigt in der oberen Abbildung: relative eingekoppelte Leistung über Einstrahlwinkel für Gaussprofil für ALO und in der untere Abbildung: Reflexionskoeffizient für p-(rot) und s-(blau)polarisiertes Licht und Winkel-Gauss-Profil für abgebildete NA=0.6 (grün), optimaler Einstrahlwinkel hier 14.5°.

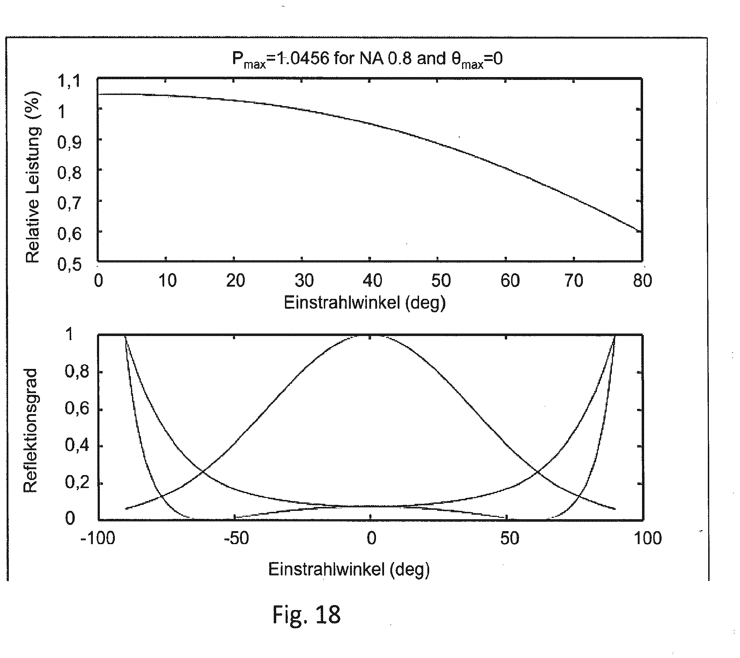

Fig. 18 zeigt in der oberen Abbildung: relative eingekoppelte Leistung über Einstrahlwinkel für Gaussprofil für ALO und in der untere Abbildung: Reflexionskoeffizient für p-(rot) und s-(blau)polarisiertes Licht und Winkel-Gauss-Profil für abgebildete NA=0.8 (grün), optimaler Einstrahlwinkel hier 0°.

Figur 19a skizziert ein Standardverfahren für das laserfreie Spalling von großflächigen Substraten. Die Waferproben, die in der Regel verwendet werden, haben scharfe Kanten um Komplikationen durch abgerundete Kanten zu vermeiden. Abgerundete Kanten werden bei herkömmlichen Wafern eingesetzt, um das Auftreten von Rissen an den Waferkanten zu verhindern, die nach innen laufen können und dann das Substrat und Fertigungsprozesse auf diesem zu stören.

Der Prozess läuft bevorzugt folgendermaßen ab: nach einem Standardreinigungsverfahren werden die Wafer mit einer Primerschicht beschichtet, um die Oberflächenhaftung zu verbessern und einer Opferschicht, um die Polymer-Wafer Trennung am Ende zu verbessern. Der Wafer wird dann mit einer PDMS-(Polydimethylsiloxan)-Polymerfolie unterschiedlicher Dicke und einem PDMS Kleber - mit Platin-Polymerisationskatalysator - beschichtet.

Die Proben werden dann auf eine Temperatur knapp über der Polymerglasübergangstemperatur vorgekühlt, bevor sie in flüssigen Stickstoff getaucht werden. Abhängig von der Größe der Probe wird die Probe bis zu 20 Sekunden später die Temperatur von flüssigem Stickstoff erreicht haben. Das System befindet sich zu diesem Zeitpunkt im thermischen Gleichgewicht. Die Halbleiterschichten trennen sich dann in einem spontan auftretenden Spalling-Ereignis. Das Spalling-Verfahren wird durch den Polymerglasübergang induziert, und als Folge dessen erhöht sich der Young-Modulus im Polymer stark. Der zusätzliche Unterschied der Wärmeausdehnungskoeffizienten (CTE) zwischen Halbleiter und Polymer induziert dann ausreichend Spannungen, um den Kristall horizontal zu trennen. Es ist wichtig, dass das Verfahren ein relatives Zusammenziehen des Polymers in Bezug auf den Halbleiter benötigt. Ein nächster Prozessschritt ist das Eintauchen der Halbleiterteile mit befestigten PDMS Folien in ein Trennbad, welches schließlich die Opferschicht auflöst und dadurch das Recycling des Polymers ebenso ermöglicht wie die Bereitstellung der Halbleiterwafer für weitere Verarbeitungsschritte.

Fig. 19a zeigt somit eine Abbildung herkömmlichen Spallings von Substraten mit einem Ensemble aus bevorzugt zwei Spannungsschichten, d.h. Polymerfolien. Die Folien werden auf beiden Seiten des Substrats befestigt, gefolgt von einem Schnellkühlschritt um die Temperaturwechselbeanspruchung, gefolgt von Rissbildung und Trennung des Substrats zu induzieren.

Der Laser-assisted-spalling-Prozess, der in 19b dargestellt ist, ist bemerkenswert ähnlich. Der Hauptunterschied ist ein zusätzlicher Laser-Verarbeitungsschritt, in dem ein Laserstrahl auf einer definierten Ebene oder auf einen definierten Verlauf in der Probe fokussiert wird, und dann die Probe abtastet. Die Laser-Schicht, die auf diese Weise erzeugt wird, definiert dann die Ebene der Rissbildung und damit auch Trennung im späteren Spalling-Prozess.

Fig. 19b zeigt somit den lasergestützten Spalling-Prozess. Zusätzlich zu den in 19a gezeigten Prozessschritten wird mittels einer mittels Laserstrahlen erzeugten Modifikationslage bzw. Laseranlage in einem weiteren Prozessschritt eine strukturell geschwächte Schicht in dem Material erzeugt, die eine bevorzugte Ebene zur Spalling-Rissausbreitung definiert.

Eine typische resultierende Waferoberfläche von laserfreiem Spalling ist in Figur 19c gezeigt. Ein Muster von Wallner-Linien ergibt sich aus der Rissausbreitung im Inneren des Materials. Rillen können an der Oberfläche des Materials ausgemacht werden, die das Rissverhalten entlang der Trennebene im Material nachzeichnen. Risse entstehen an den Kanten der Probe und wandern nach innen, wodurch ein detailliertes Muster, wie in Figur 19c entsteht. Die vierfache Symmetrie des Musters ist eine Folge der vierfachen Kristallsymmetrie im Silizium, mit einer Singularität oder einem Mittelpunkt der Risswellen in der Mitte der Probe. Um technologisch in Wettbewerb mit Drahtsägeprozessen zu treten, ist jedoch die Oberflächenqualität nach der Trennung von entscheidender Bedeutung für jeden Spalling-Prozess. Die sich ergebende Gesamtdickenvariation (TTV) von Spalling-Oberflächen ohne Laserprozess ist jedoch üblicherweise weit über den Branchenanforderungen. Das typische TTV von Spalling-Prozessen ist in der Größenordnung von 50 $\mu$m, wobei hier Schleifschritte vor der Weiterverarbeitung erforderlich wären, die die Kosten zu hoch treiben würden. Die Verwendung des LAS-Prozesses führt stattdessen zu Oberflächenrauheitswerten von Sa <1$\mu$m wurden erreicht. Sa ist der arithmetische Mittelwert der absoluten Werte der Oberflächenkoordinaten z (x, y).

Fig. 19c zeigt somit eine Aufnahme einer Hälfte eines 300-mm-Siliziumwafer nach der Trennung unter Verwendung herkömmlichen Spallings. Wallner-Linien sind deutlich sichtbar als Rissrillen und bezeichnend für hohe Oberflächenhöhenvariation (TTV).

Fig. 19d zeigt eine Aufnahme einer Hälfte eines 300-mm-Siliziumwafers nach lasergestütztem Spalling. Die Oberfläche ist homogen mit einer Oberflächenrauheit unter 1 $\mu$m und ohne sichtbare Streifen von der Rissausbreitung. Die vertikale Linie auf der linken Seite des Substrats stammt von einer Limitierung des Verfahrwegs des Substrathaltetisches der Laseranlage.

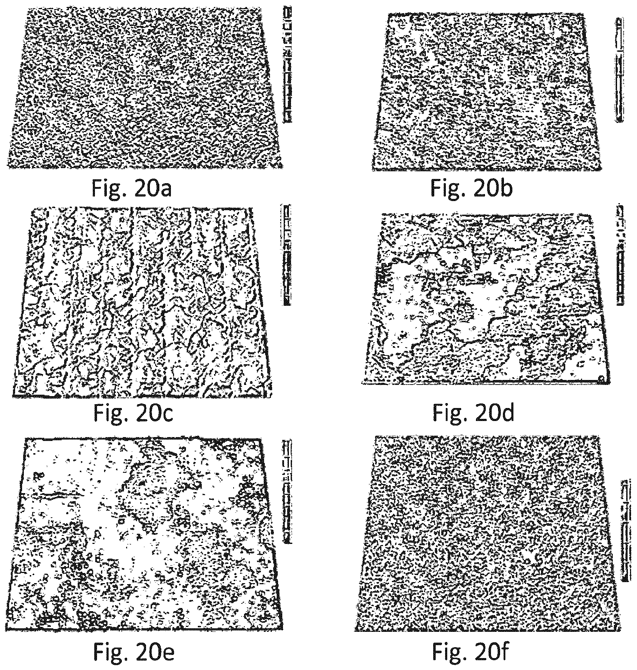

Die Figuren 20a-f zeigen eine Übersicht der Materialoberflächen nach lasergestütztem Spalling. Fig. 20a zeigt eine Siliziumoberfläche von der in Abbildung 19d dargestellten Probe, mit einer Oberflächenrauhigkeit von Sa = 0.79$\mu$m. Fig. 20b zeigt ein Saphir (Al$_2$O$_3$) Substratoberfläche (C-Ebene) nach lasergestütztem Spalling, mit einer Oberflächenrauhigkeit von Sa = 1.96$\mu$m. Fig. 20c und Fig. 20d zeigen Oberflächen von Siliciumcarbid Polymorphen 4H und 6H (beides mit N-Dotierung) nach lasergestütztem Spalling mit Oberflächenrauhigkeiten Sa = 1.85$\mu$m und Sa = 1.29$\mu$m. Fig. 20e zeigt ein Beispiel für Spalling von nicht-kristallinem Material, Oberfläche von polykristallinem Al$_2$O$_3$, mit einer Oberflächenrauhigkeit Sa = 3.89$\mu$m. Fig. 20f zeigt Quarzglas, Prinzipstudie, Versuch von lasergestütztem Spalling, mit Oberflächenrauheit von Sa = 6.89$\mu$m.

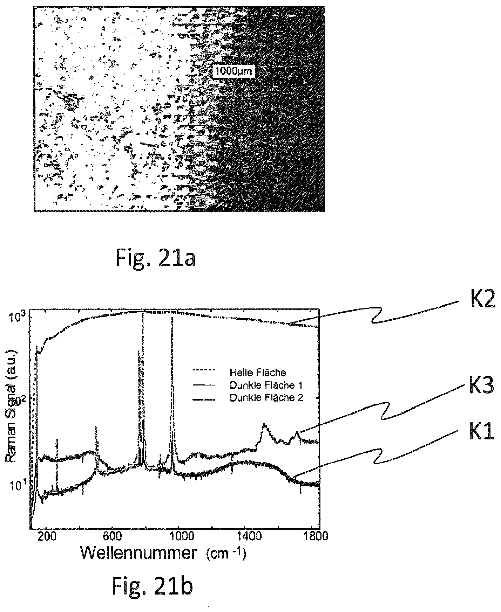

Fig. 21a zeigt eine mikroskopische Aufnahme einer Oberfläche nach dem Spalling. Fig. 21b zeigt Raman-Spektren von drei verschiedenen Stellen in 6H-Siliziumkarbid. Die Raman-Spektren vom dunkleren Bereich (auf der rechten Seite von Fig. 21a) sind Kurve K1 und Kurve K2, mit der Kurve K3 als Raman-Spektrum vom helleren Bereich auf der linken Seite in Fig. 21a. Die Peak-Höhe ist für die dunkleren Bereiche reduziert für fast alle Peaks und an der Position 2 im dunkleren Bereich sind keine Raman-Peaks mehr erkenntlich.

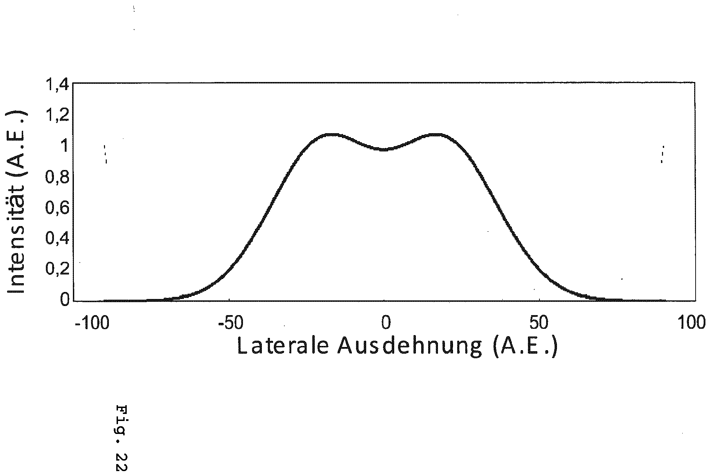

Fig. 22 zeigt ein weiteres zusätzliches oder alternatives Strahlprofil. Bei einer Brewster-Beaufschlagung mit hohen numerischen Aperturen ist erfindungsgemäß das Strahlprofil des Lasers anpassbar. Somit kann bei hoher NA mehr Intensität in den Flanken des eingestrahlten Laserstrahlprofils resultieren. Im Extrem ist das eine Art Donut-Profil mit einem klaren Intensitätsminimum in der Mitte. Es ist aber ebenfalls denkbar, dass das Laserstrahlprofil als ein in der Mitte abgeflachtes Gauss-Profil gestaltet ist. Es wird somit bevorzugt der Umstand ausgenutzt, dass bei hoher NA die Randbereiche des Laserprofils bereits in die Nähe des Brewster-Winkels geraten können. Das durch Fig. 22 dargestellte Beispielprofil könnte somit bevorzugt mit relativ höherem Intensitätsanteil (gegenüber den anderen Ausführungsformen) in den Flanken erzeugt werden.

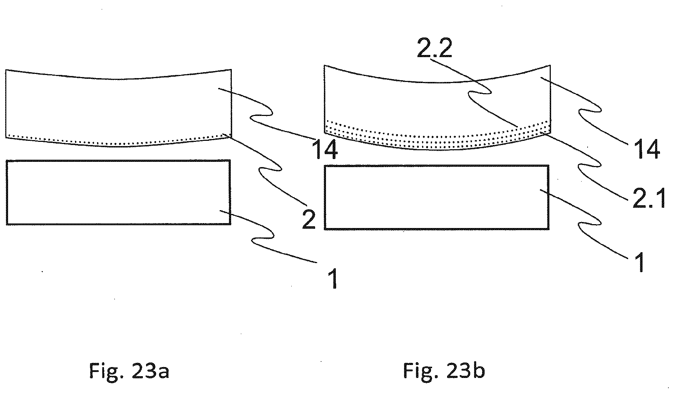

Fig. 23 a beschreibt eine erste Festkörpererzeugungskonfiguration. Gemäß dieser Konfiguration ist es möglich die Festkörperschicht 14 von dem Festkörper 1 abzutrennen. Gemäß dieser Konfiguration wird eine erste Anzahl an Modifikationen 2 in dem Festkörper erzeugt. Die Modifikationen 2 bewirken dabei bevorzugt bereits eine Durchbiegung der abgespalteten Festkörperschicht 14.

In Fig. 23b ist eine zweite Festkörpererzeugungskonfiguration dargestellt. Gemäß dieser Konfiguration ist es ebenfalls möglich die Festkörperschicht 14 von dem Festkörper abzutrennen. Gemäß dieser Konfiguration wird jedoch eine zweite Anzahl an Modifikationen 2 in dem Fesktkörper 1 erzeugt. Die zweite Anzahl an Modifikationen 2 ist dabei bevorzugt größer als die erste Anzahl an Modifikationen. Zusätzlich oder alternativ ist es möglich, dass die Konfiguration mehrere Modifikationslagen 2.1, 2.2 aufweist oder mehr Modifikationslagen 2.1, 2.2 aufweist als die erste Konfiguration, in der ebenfalls mehrere Modifikationslagen vorgesehen sein können. Zusätzlich oder alternativ ist ebenfalls denkbar, dass einzelne oder die Mehrzahl der Modifikationen 2 gemäß der zweiten Konfiguration stärker ausgebildet sind als in der ersten Konfiguration. Stärker ausgebildet bedeutet hierbei bevorzugt, dass sich die einzelnen Modifikationen jeweils über ein größeres Volumen erstrecken als in der ersten Konfiguration. Die Laserstrahlen 10 dringen dabei bevorzugt in Längsrichtung des Festkörpers 1 oder in einem Winkel von bis zu 60° geneigt zur Längsrichtung L des Festkörpers 1 über eine, insbesondere ebene, Oberfläche, die bevorzugt Bestandteil der Festkörperschicht ist, in den Festkörper 1 ein und der Rissführungsbereich 4 wird dabei dann bevorzugt aus mehreren Lagen an Modifikationen 2 gebildet. Die Lagen werden dabei bevorzugt in Längsrichtung L zueinander beabstandet oder versetzt erzeugt. Bevorzugt weisen zumindest mehrere der Modifikationen 2 eine Ausdehnung in Längsrichtung L auf, die zwischen 1 und 50 μm beträgt, und/oder die Laserstrahlen 10 werden bevorzugt derart zum Erzeugen der Modifikationen 2 in den Festkörper 1 eingeleitet, dass die numerische Apertur kleiner als 1 bevorzugt kleiner als 0,9 oder kleiner 0,8 oder kleiner als 0,7 oder kleiner als 0,6 oder kleiner als 0,5 ist.

Somit beschreibt die Erfindung ein Verfahren zum Abtrennen von mindestens einer Festkörperschicht von einem Festkörper, wobei durch die Modifikationen ein Rissführungsbereich zum Führen eines Risses zum Abtrennen eines Festkörperanteils, insbesondere einer Festkörperschicht, von dem Festkörper vorgegeben wird, mindestens umfassend die Schritte: Bewegen des Festkörpers relativ zu einer Laserbeaufschlagungseinrichtung, nacheinander Erzeugen von Laserstrahlen mittels der Laserbeaufschlagungseinrichtung zum Erzeugen von jeweils mindestens einer Modifikation, wobei die Laserbeaufschlagungseinrichtung zur definierten Modifikationserzeugung in Abhängigkeit von zumindest einem Parameter, insbesondere der Transmission des Festkörpers, an definierten Stellen und für eine definierte Festkörpertiefe, eingestellt wird, wobei durch die Einstellung der Laserbeaufschlagungseinrichtung Inhomogenitäten des Festkörpers im Bereich der beaufschlagten Oberfläche und/oder im Bereich des Beaufschlagten Volumens des Festkörpers ausgeglichen werden, Abtrennen der Festkörperschicht von dem Festkörper.

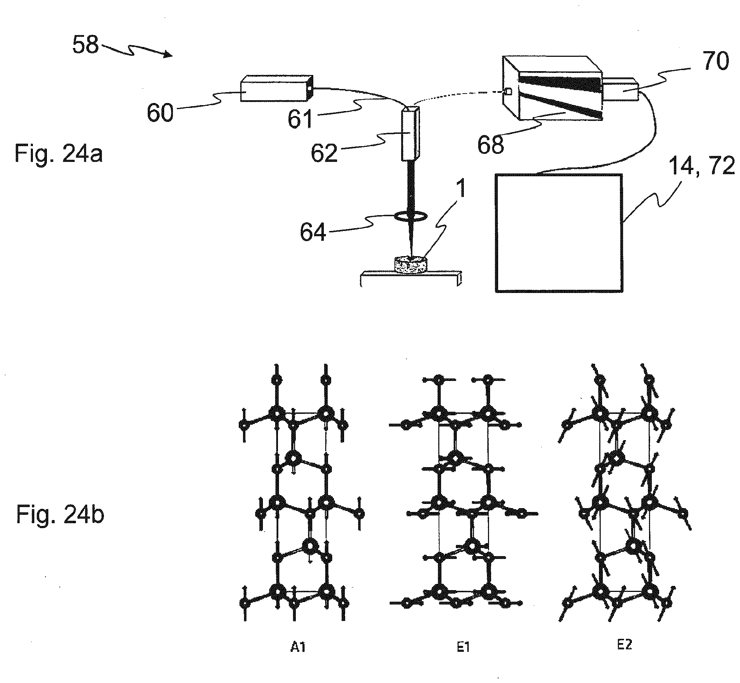

Fig. 24a zeigt ein Raman-Instrument 58. Das hier gezeigte Raman-Instrument 58 weist einen Laser 60 zum Emittieren von Strahlung auf. Die Strahlung wird bevorzugt mittels mindestens einer optischen Faser 61 für eine Anregung bevorzugt einer Optik zugeführt und von dieser Optik, insbesondere Linse 64, bevorzugt fokussiert, insbesondere in den Festkörper fokussiert. Diese Strahlung wird zumindest teilweise gestreut, wobei bevorzugt mittels einer Filtereinrichtung bzw. Anregungsfilter 62 Lichtanteile herausgefiltert werden, welche dieselbe Wellenlänge wie die vom Laser emittierte Strahlung aufweisen. Die sonstigen Strahlungsanteile werden dann einem Spektrographen 68 zugeführt und mittels einer Kameraeinrichtung, insbesondere einem CCD-Detektor 70 erfasst und von einer Steuerungseinrichtung 14, 72, insbesondere einem Computer, ausgewertet bzw. aufbereitet.

Es werden somit bevorzugt Atomschwingungen im Kristall durch einen bevorzugt externen oder besonders bevorzugt weiteren Laser angeregt. Diese Schwingungen werden durch Lichtstreuung an Kristallatomen erzeugt, was zu beobachtbarem gestreutem Licht führt, was eine um den Betrag der Schwingungsenergie veränderte Photonenenergie aufweist. Bei mehreren anregbaren Schwingungen treten auch mehrere Peaks im Spektrum des gestreuten Lichts auf. Mit einem Spektrometer (Gitterspektrometer) kann dann das entstandene Raman-Streuungsspektrum näher untersucht werden (sog. Raman-Spektroskopie). Bei dieser Methode sind den einzelnen Raman-Linien in ihrer Form die lokalen Bedingungen im Kristall aufgeprägt und durch eine Analyse der Form der Raman-Linie kann auf den Dotiergrad rückgeschlossen werden.

Fig. 24b zeigt, wie mögliche Gitterschwingungen in SiC aussehen, wobei diese Moden durch Kristallsymmetrie und Richtungen vorgegeben sind und auch gleichzeitig angeregt sein können. Die gezeigten Ansichten weisen eine Erstreckung entlang der Kristallachse A auf. Hierbei sind Schwingungen der Atome nur in bestimmten Richtungen möglich, wobei die Richtungen durch die Symmetrie des Kristalls vorgegeben sind.

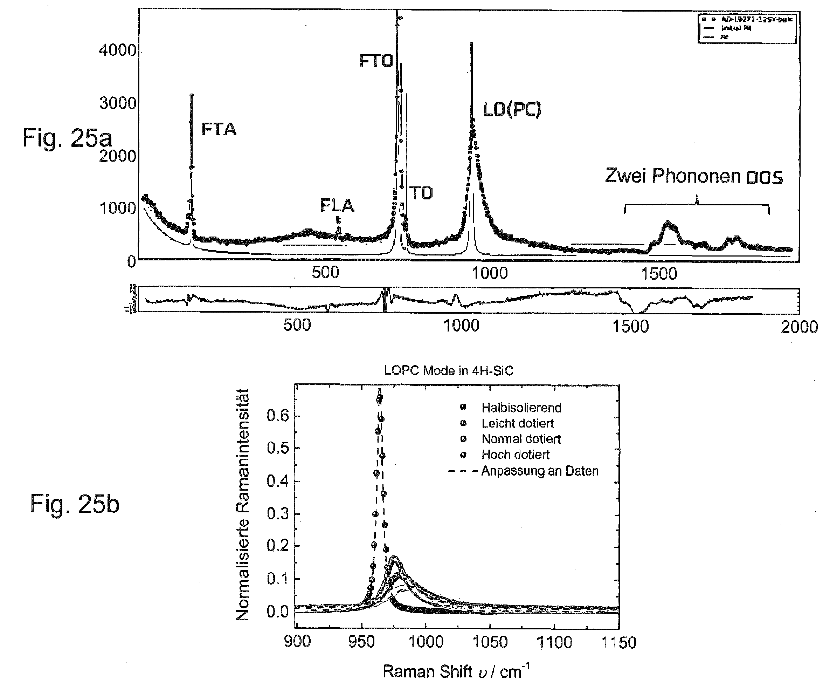

Fig. 25a zeigt einen Ausschnitt eines Raman-Verlaufs, eines mit Stickstoff dotierten 4H-Siliziumcarbid-Festkörpers (Beispielspektrum für Raman an dotiertem SiC). Hierbei wird die Form der LO(PC)-Mode rur Messung der Dotierkonzentration herangezogen und gefittet. Unteres Panel: Fitting-Residual.

Fig. 25b zeigt einen kleineren Ausschnitt des Raman-Verlaufs.

Wie dargestellt ergibt sich eine direkte Methode, um mit Raman-Messungen die Dotandenkonzentration zu bestimmen aus einer Messung der Form und folgendem Fit an die LO(PC)-Mode.

Generell ist es somit das Ziel, durch Einstellen der Laserparameter den optimalen (kleinstmöglichen, kürzestmöglichen) Rissverlauf im Material einzustellen, der immer noch zu erfolgreichem Trennen infolge einer Rissausbreitung führt, jedoch anderweitig alle Materialverluste (auch in Schleifschritten) minimiert bzw. reduziert.

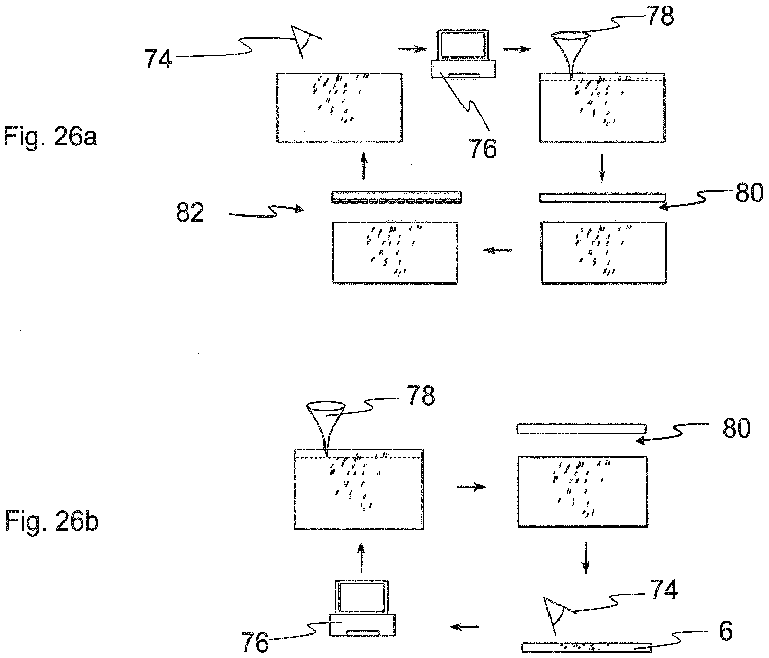

Fig. 26a und Fig. 26b zeigen zwei Möglichkeiten, das Abheben einzelner Wafer vom Boule/Ingot zu gestalten.

Gemäß Fig. 26a wird dies als Feedforward-Loop und gemäß Fig. 26b als Feedback-Loop ausgestaltet.

Beim Feedforward wird die Verteilung vor dem Laserprozess charakterisiert und daraus eine Karte bzw.

Behandlungsanweisungen bzw. Parameteranpassungen, insbesondere ortsabhängig, für den Laserprozess, insbesondere die Modifikationserzeugung, berechnet. Feedforward wird bevorzugt am Ingot/Boule durchgeführt.

Alternativ kann, wie in Fig. 26b dargestellt, ein Feedback-Loop implementiert werden, gemäß dem nach jedem Trennschritt der entstandene Wafer charakterisiert wird und als Vorlage für den nächsten dient.

Je nach Material und Dotierung können somit unterschiedliche Anpassungen während des Laserprozesses vorgenommen werden:

Bei dem Material SiC können in unterschiedlichen Tiefen unterschiedliche Anpassungen der Laserparameter in Abhängigkeit von der auftretenden Dotierung vorgenommen werden. Dies kann bei den nachfolgend genannten Randbedingungen zu den ebenfalls nachfolgend genannten Funktionen führen:

Tiefe 180$\mu$m, Pulsdauer 3ns, numerische Apertur 0.4

| | |
|---|---|
| Niedrige Dotierung: | 7$\mu$J - 21 mOhmcm |
| hohe Dotierung: | 8$\mu$J 16mOhmcm |

Tiefe 350$\mu$m, Pulsdauer 3ns, numerische Apertur 0.4

| | |
|---|---|
| Niedrige Dotierung: | 9.5$\mu$J - 21mOhmcm |
| hohe Dotierung: | 12$\mu$J - 16mOhmcm |

Formel für 180$\mu$m Tiefe:

E    Energie in $\mu$J
E0   Offset-Energie bei niedrigster Dotierung
K    Faktor Energieskalierung
R    gemessener Dotiergrad
B    Basisdotiergrad (21 mOhmcm)

$$E = E0+(B-R)*K$$

Hier

K = 1/(21-16) $\mu$J/mOhmcm = 0,2$\mu$J/mOhmcm
E0 = 7$\mu$J
B = 21mOhmcm

Beispiel: gemessener Dotiergrad von 19mOhmcm: E = 7,4$\mu$J

Formel für 350$\mu$m Tiefe:

E    Energie in $\mu$J
E0   Offset-Energie bei niedrigster Dotierung
K    Faktor Energieskalierung
R    gemessener Dotiergrad
B    Basisdotiergrad (21 mOhmcm)

$$E = E0+(B-R)*K$$

Hier

K = 2,5/(21-16) $\mu$J/mOhmcm = 0,5$\mu$J/mOhmcm
E0 = 95$\mu$J
B = 21 mOhmcm

Beispiel: gemessener Dotiergrad von 19mOhmcm: E = 10,5$\mu$J

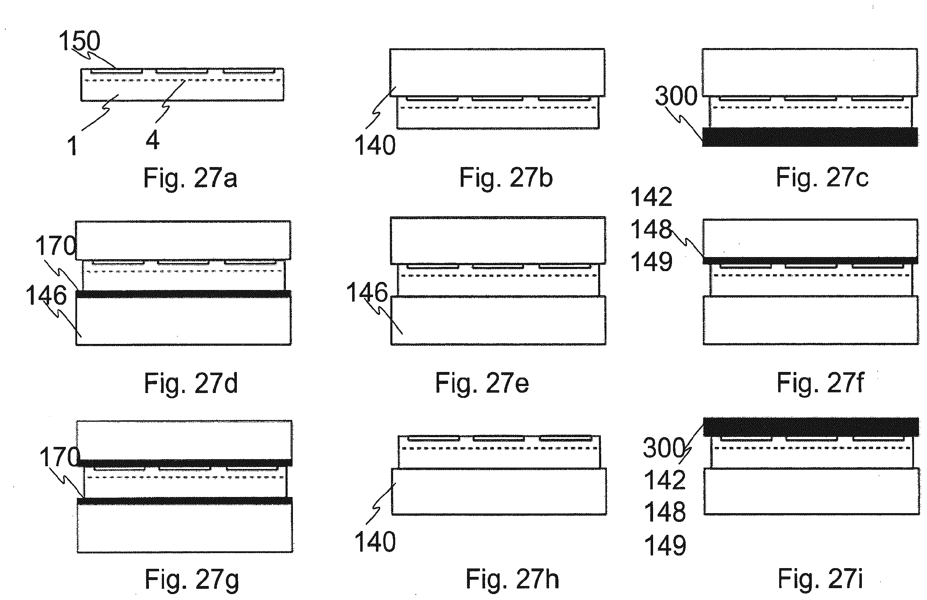

Die Figuren 27a bis 27i zeigen verschiedene Anordnungen, die nach der Erzeugung der weiteren Materialschichten bzw. Bauteile 150 zum Einleiten des Risses vorgesehen werden können.

Die Figuren 27a-27i zeigen diverse Festkörperanordnungen 176, wie sie zum Einleiten von Rissführungs- und/oder Rissauslösungsspannungen vorteilhaft sind.

Fig. 27a zeigt hierbei einen prozessierter Festkörper 1 bzw. Wafer mit Strukturen bzw. Bauteilen 150.

Gegenüber dem in Fig. 27a gezeigten Festkörper 1 ist bei dem in Fig. 27b gezeigten Festkörper 1 eine Aufnahmeschicht 140 an der Bauteilseite, insbesondere an den Bauteilen 150 bzw. den weiteren Materialschichten 150, angeordnet oder erzeugt. Die Aufnahmeschicht 140 ist hierbei bevorzugt an der abzutrennenden Festkörperschicht angeordnet. Die Aufnahmeschicht 140 kann hierbei auch als Splitfolie bezeichnet werden und ist somit bevorzugt auf der Strukturseite auflaminiert. Im Nachfolgeschritt erfolgt dann ein Abkühlen der Gesamtanordnung, wodurch der Split bzw. die Rissauslösung und/oder Rissführung bewirkt wird.

Gegenüber der Darstellung der Fig. 27b ist gemäß der Fig. 27c an der Unterseite des Festkörpers bzw. an der freiliegenden Oberfläche des Festkörpers eine Halteschicht/gebondeter Wafer angeordnet. Es kann sich bei der Halteschicht auch um einen Werkzeugträger bzw. Chuck 300 handeln. Im Nachfolgeschritt erfolgt dann ein Abkühlen der Gesamtanordnung, wodurch der Split bzw. die Rissauslösung und/oder Rissführung bewirkt wird.

Fig. 27d zeigt gegenüber der Fig. 27b eine Anordnung, gemäß welcher der Festkörper doppelseitig mit Aufnahmeschichten 140, 146 versehen ist. Die weitere Aufnahmeschicht 146 ist dabei an einer Oberfläche des später verbleibenden Restfestkörpers angeordnet, wobei zwischen der weiteren Aufnahmeschicht 146 und dem Festkörper 1 eine Haftvermittlungsschicht 148 und/oder Opferschicht 149 und/oder Schutzschicht 142 angeordnet oder erzeugt sein kann. Die beiden Aufnahmeschichten 140 und 146 sind bevorzugt auflaminiert. Im Nachfolgeschritt erfolgt dann ein Abkühlen der Gesamtanordnung, wodurch der Split bzw. die Rissauslösung und/oder Rissführung bewirkt wird.

Fig. 27e zeigt eine Anordnung, gemäß der gegenüber der aus Fig. 27d bekannten Anordnung keine Haftvermittlungsschicht 148 und/oder Opferschicht 149 und/oder Schutzschicht 142 zwischen der weiteren Aufnahmeschicht 146 und dem Festkörper 1 angeordnet oder erzeugt ist. Im Nachfolgeschritt erfolgt dann ein Abkühlen der Gesamtanordnung, wodurch der Split bzw. die Rissauslösung und/oder Rissführung bewirkt wird.

Fig. 27f zeigt eine Anordnung die invers zu der aus Fig. 27d bekannten Anordnung aufgebaut ist, d.h., dass die Haftvermittlungsschicht 148 und/oder Opferschicht 149 und/oder Schutzschicht 142 nicht zwischen der weiteren Aufnahmeschicht 146 und dem Festkörper 1 angeordnet oder erzeugt ist, sondern zwischen der Aufnahmeschicht 140 und dem Festkörper 1 und somit an der abzutrennenden Festkörperschicht erzeugt oder angeordnet ist/sind. Auf den Bauteilen 150 oder den Strukturen kann hierbei z.B. mittels Spinncoating eine oder mehrere Schichten erzeugt werden. Als Nachfolgeschritt erfolgt dann ein Abkühlen der Gesamtanordnung, wodurch der Split bzw. die Rissauslösung und/oder Rissführung bewirkt wird.

Fig. 27g zeigt eine Anordnung bzw. Ausprägung, die einer Kombination aus den Anordnungen der Figuren 27d und 27f entspricht. Der Festkörper ist bevorzugt doppelseitig mit Splitfolie laminiert, ebenso kann doppelseitig eine Schutzschicht und/oder Haftvermittlungsschicht und/oder Opferschicht unter der Splitfolie vorgesehen sein, auf den Strukturen ist ferner z.B. Spincoating möglich. Als Nachfolgeschritt erfolgt dann ein Abkühlen der Gesamtanordnung, wodurch der Split bzw. die Rissauslösung und/oder Rissführung bewirkt wird.

Fig. 27h zeigt eine Anordnung, die ähnlich zur in Fig. 27b gezeigten Anordnung ist, wobei die Aufnahmeschicht nicht auf einer Oberfläche der abzutrennenden Festkörperschicht, sondern auf dem nach der Abtrennung verbleibenden Restfestkörper einseitig angeordnet bzw. laminiert ist. Die Abtrennung erfolgt dann infolge der Abkühlung analog zur Abtrennung von einem Ingot bzw. wie in einem Ingot-Prozess.

Fig. 27i zeigt eine Anordnung, die ähnlich zur aus Fig. 27c bekannten Anordnung ist, wobei eine oder mehrere der nachfolgend genannten Schichten oder Einrichtungen an der Bauteilseite des Festkörpers bzw. an oder oberhalb der Bauteile 150 angeordnet oder erzeugt wird/werden. Diese Schichten oder Einrichtungen sind dabei bevorzugt: Mindestens oder genau eine Haftvermittlungsschicht 148 und/oder mindestens oder genau eine Opferschicht 149 und/oder mindestens oder genau eine Schutzschicht 142 und/oder mindestens oder genau eine Stabilisierungseinrichtung 3, insbesondere ein Werkzeugträger oder Chuck 300 (bevorzugt Kühleinrichtung) oder ein weiterer Wafer. Als Nachfolgeschritt erfolgt dann ein Abkühlen der Gesamtanordnung, wodurch der Split bzw. die Rissauslösung und/oder Rissführung bewirkt wird.

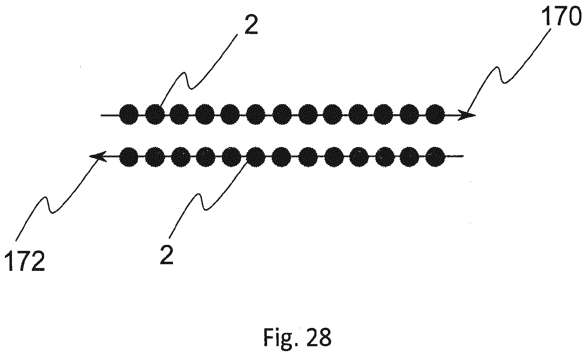

Fig. 28 zeigt eine Illustration eines Beispiels für ein Schreibmuster bei einer X-Y-Bearbeitung:

Pfeile 170, 172 repräsentieren die Laservorschubrichtung, die schwarzen Kreise repräsentieren die unterschiedlichen Laserschüsse bzw. Modifikationen 9, die hier mit ihrer Schadwirkung im Material nicht überlappen. Es ist hierbei bevorzugt, wenn der Laser zunächst in eine Richtung fährt und Modifikationen 9 erzeugt, bevor er umkehrt und Modifikationen 9 in der zweiten (unteren) Richtung schreibt.

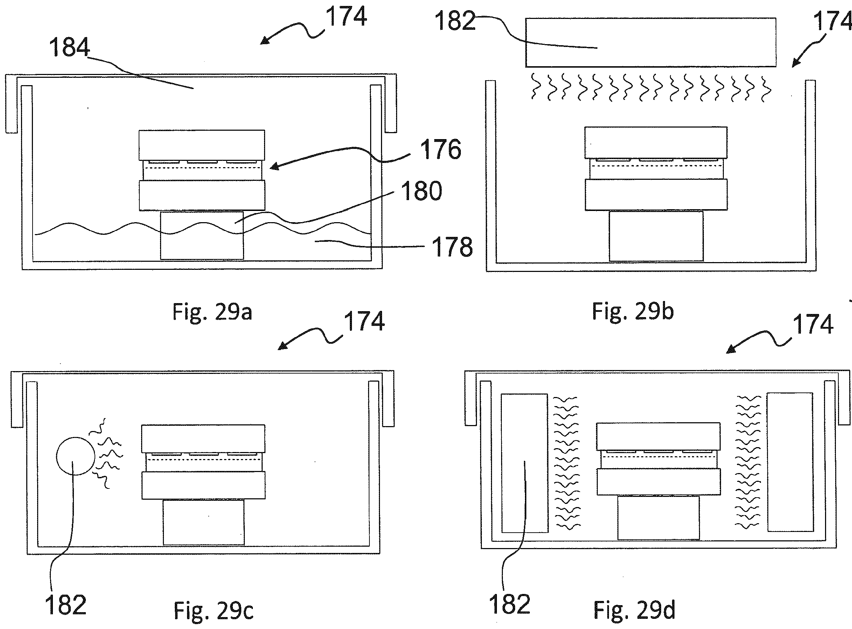

Die Figuren 29a bis 29d zeigen verschiedene Kühleinrichtungen 174. Die in diesen Kühleinrichtungen 174 prozessierten Festkörperanordnungen 176 resultieren aus den verschiedenen in den Figuren 27a bis 27i gezeigten und beschriebenen Ausprägungen bzw.

Gestaltungen der mit einer oder mehreren Aufnahmeschicht/en 140, 146 versehenen Festkörper 1. Die hierin gezeigten Kühleinrichtungen 174 verwenden alle zum Kühlen ein verfüssigtes Gas 178 als Ausgangskühlmedium. Dieses Ausgangskühlmedium wird je nach Ausführungsform entweder vernebelt oder verdampft. Bevorzugt handelt es sich bei dem Ausgangskühlmedium um flüssigen Stickstoff. Alternative Kühlverfahren z.B. mittels Piezoelementen sind ebenfalls vorstellbar und möglich.

Die Kühleinrichtung 174 dient dabei bevorzugt zum Abkühlen der Aufnahmeschicht 140, 146 auf eine Temperatur zwischen -85°C und -10°C, insbesondere auf eine Temperatur zwischen -80°C und -50°C.

Gemäß Fig. 29a weist die Kühleinrichtung 174 ein Stickstoffbad auf, wobei die Aufnahmeschicht beabstandet, insbesondere mittels einer einstellbaren Positioniereinrichtung 180, zu in dem Stickstoffbad vorgehaltenen flüssigen Stickstoff positioniert wird. Somit wird die Festkörperanordnung bevorzugt auf einer Positioniereinrichtung bzw. auf einer Halterung über einem Stickstoffbad angeordnet. Es resultiert somit ein Temperaturgradient über die Kammerhöhe und die Temperatur an der Festköperanordnung ist über die Füllhöhe mit dem Ausgangskühlmedium oder die Position der Festkörperanordnung 176 (Abstand zum Boden der Kammer) einstellbar.

Gemäß den Ausführungsformen der Figuren 29b bis 29d kann die Kühleinrichtung bevorzugt ein Vernebelungsmittel, insbesondere mindestens oder genau eine perforierte Rohrleitung, zum Vernebeln von flüssigem Stickstoff oder ein Vernebelungsmittel zum Vernebeln von flüssigem Stickstoff aufweisen und die Kühlwirkung durch vernebelten oder verdampften Stickstoff erzeugt werden.

Gemäß Fig. 29b wird bevorzugt ein homogenes Sprühgerät/Nebler zum Sprühen oder Vernebeln bereitgestellt. Das Sprühen oder Vernebeln erfolgt bevorzugt oberhalb der Festkörperanordnung 176. Ferner erfolgen bevorzugt Temperaturmessungen zur Temperaturkontrolle, die Ausgangsdaten zum Regelten eines Ventils, insbesondere Stickstoffventils, ausgeben. Die Temperaturmessungen erfolgen bevorzugt am Substrat bzw. am Festkörper 1 oder an der Aufnahmeschicht 140.

Das Substrat bzw. der Festkörper 1 bzw. die Festkörperanordnung 176 ruht bevorzugt über dem Kammerboden um Stickstoffabsetzen am Boden der Kammer auszuweichen.

Gemäß Fig. 29c wird bevorzugt eine perforierte Rohrleitung als homogenes Sprühgerät verwendet. Ferner erfolgen bevorzugt Temperaturmessungen zur Temperaturkontrolle, die Ausgangsdaten zum Regelten eines Ventils, insbesondere Stickstoffventils, ausgeben. Die Temperaturmessungen erfolgen bevorzugt am Substrat bzw. am Festkörper 1 oder an der Aufnahmeschicht 140.

Das Substrat bzw. der Festkörper 1 bzw. die Festkörperanordnung 176 ruht bevorzugt über dem Kammerboden um Stickstoffabsetzen am Boden der Kammer auszuweichen.

Gemäß Fig. 29d zeigt eine Kühleinrichtung 176 die ein homogenes Sprühgerät/Nebler 182 zum Kühlen von bevorzugt mehreren bzw. jeder Seite aufweist. Ferner erfolgen bevorzugt Temperaturmessungen zur Temperaturkontrolle, die Ausgangsdaten zum Regelten eines Ventils, insbesondere Stickstoffventils, ausgeben. Die Temperaturmessungen erfolgen bevorzugt am Substrat bzw. am Festkörper 1 oder an der Aufnahmeschicht 140.

Das Substrat bzw. der Festkörper 1 bzw. die Festkörperanordnung 176 ruht bevorzugt über dem Kammerboden um Stickstoffabsetzen am Boden der Kammer auszuweichen.

Die Kammer 184 der Kühleinrichtung 174 ist bevorzugt verschlossen um einen Temperaturgradient möglichst durch Isolation zu vermindern.

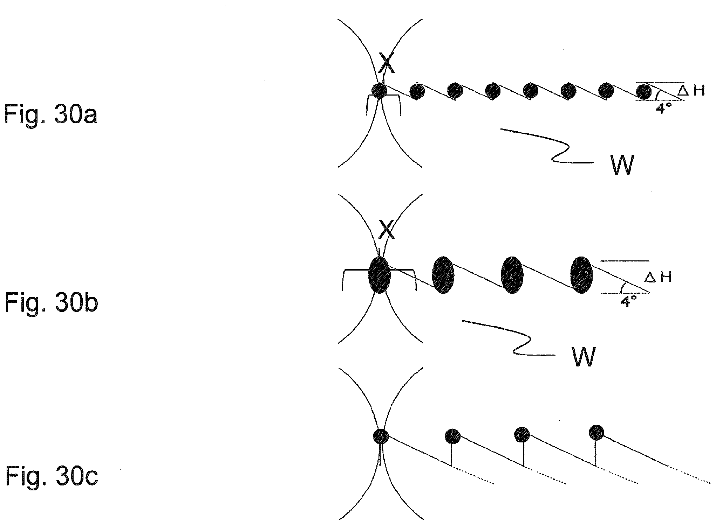

Fig. 30 zeigt drei Beispiele für bevorzugte Zusammenhänge zwischen der Kristallgitterorientierung und der Modifikationserzeugung. Dieses Verfahren ist insbesondere für das Abtrennen von Festkörperschichten von einem aus SIC bestehenden oder SiC aufweisenden Festkörper sinnvoll. Durch diese Zusammenhänge ergibt sich ein weiteres erfindungsgemäßes Verfahren. Dieses weitere erfindungsgemäße Verfahren dient bevorzugt zum Abtrennen von mindestens einer Festkörperschicht von mindestens einem Festkörper 1, insbesondere von einem Wafer von einem Ingot oder zum Dünnen eines Wafers. Das weitere erfindungsgemäße Verfahren umfasst dabei bevorzugt mindestens die Schritte: Erzeugung einer Vielzahl an Modifikationen 2 mittels Laserstrahlen im Inneren des Festkörpers 1 zum Ausbilden einer Ablöseebene 4, und Einleiten einer äußeren Kraft in den Festkörper 1 zum Erzeugen von Spannungen in dem Festkörper 1, wobei die äußere Kraft so stark ist, dass die Spannungen eine Rissausbreitung entlang der Ablöseebene 4 bewirkt.

Erfindungsgemäß werden die Modifikationen nacheinander in mindestens einer Zeile oder Reihe oder Linie erzeugt, wobei die in einer Zeile oder Reihe oder Linie erzeugten Modifikationen 2 bevorzugt in einem Abstand X und mit einer Höhe H erzeugt werden, damit ein sich zwischen zwei aufeinander folgenden Modifikationen ausbreitender Riss, insbesondere in Kristallgitterrichtung ausbreitender Riss, dessen Rissausbreitungsrichtung in einem Winkel W gegenüber der Ablöseebene ausgerichtet ist, die beiden Modifikationen miteinander verbindet. Der Winkel W liegt hierbei bevorzugt zwischen 2° und 6°, insbesondere bei 4°. Bevorzugt breitet sich der Riss von einem Bereich unterhalb des Zentrums einer ersten Modifikation hin zu einem Bereich oberhalb des Zentrums einer zweiten Modifikation hin aus. Der hierbei wesentliche Zusammenhang ist daher, dass die Größe der Modifikation in Abhängigkeit des Abstands der Modifikationen und des Winkels W verändert werden kann bzw. muss.

Ferner kann dieses Verfahren auch den Schritt des Erzeugens einer Kompositstruktur durch Anordnen oder Erzeugen von Schichten und/oder Bauteilen 150 an oder oberhalb einer zunächst freiliegenden Oberfläche des Festkörpers 1 aufweisen, wobei die freiliegende Oberfläche bevorzugt Bestandteil der abzutrennenden Festkörperschicht ist. Besonders bevorzugt werden die Modifikationen zum Ausbilden der Ablöseebene 4 vor der Erzeugung der Kompositstruktur erzeugt.

Zum Einleiten der äußeren Kraft kann z.B. analog zu den zuvor beschriebenen Verfahren eine Aufnahmeschicht 140 an einer freiliegenden Oberfläche der Kompositstruktur bzw. des Festkörpers angeordnet werden.

Die drei Abbildungen 30a bis 30c sollen verdeutlichen, wie die Größe der durch Laser amorphisierten/phasenumgewandelten Schad-/Modifikationszone die vom Sägezahnmuster des Risses durchlaufene Höhe beeinflusst. Generell läuft der Riss entlang der Kristallebenen also zwischen einzelnen Atomen des Kristalls. In der modifizierten Zone sind diese klaren Ebenen nicht mehr existent, der kommt also zum Halt.

Durch eine bevorzugt möglichst hohe numerische Apertur kann die Schadzone entlang der Strahlrichtung verkleinert werden, wie auch lateral in der Brennebene. Da nur die Schwellintensität erreicht werden muss, genügt hier dann auch eine kleinere Pulsenergie.

Wenn nun die Schadzone geeigneterweise kleiner ausgebildet ist, so können die Lasermodifikationen dichter gesetzt werden, was den Sägezahn kürzer laufen lässt und insgesamt eine geringere Höhenausdehnung der modifizierten Ebene bedingt (erstes Bild).

Ist die Schadzone hingegen größer ausgebildet (höhere Energie und/oder niedrigere numerische Apertur - Fig. 30b) - wird durch den erhöhten Druck der amorphisierten Zone auch ein größerer Mikroriss ausgelöst, den einzufangen (d.h. kontrolliert zu stoppen) man mit einer Schadzone größerer Ausdehnung in größerem Abstand ermöglicht.

Fig. 30c schließlich zeigt die Gefahr auf, wenn die Schadzone nicht ausreichend groß ist und zu weit laufende Risse durch die Lasermodifikation ausgelöst werden, die Risse laufen zum einen zu weit - d.h. der durch die Risse entstandene Höhenunterschied wird größer als gewünscht - und zum anderen werden die Risse unter den weiteren Schadzonen hindurchgetrieben und nicht vom amorphisierten Material gestoppt. Dies führt dann wieder zu Materialverlusten, da alle eingerissenen Materialschichten für das Endprodukt oder eine erneute Laserbearbeitung entfernt werden müssen.

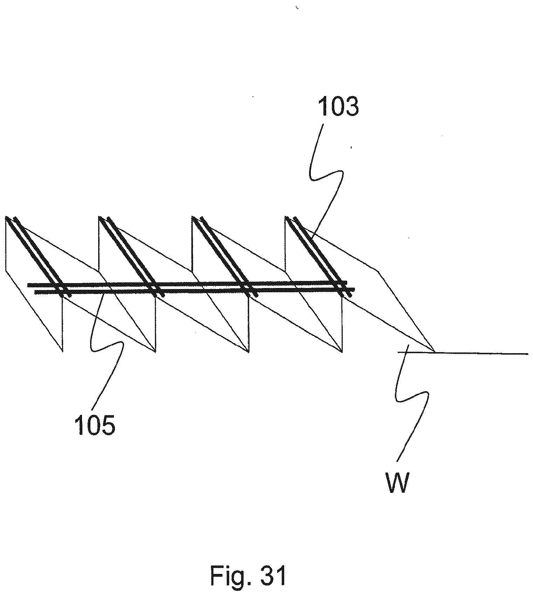

Fig. 31 zeigt eine schematisch dargestellte Momentaufnahme aus einem weiteren erfindungsgemäßen Verfahren. Dieses weitere Verfahren dient bevorzugt zum Abtrennen von mindestens einer Festkörperschicht von mindestens einem Festkörper 1, insbesondere von einem Wafer von einem Ingot oder zum Dünnen eines Wafers. Das weitere erfindungsgemäße Verfahren umfasst dabei bevorzugt mindestens die Schritte: Erzeugung einer Vielzahl an Modifikationen 2 mittels Laserstrahlen im Inneren des Festkörpers 1 zum Ausbilden einer Ablöseebene 4, und Einleiten einer äußeren Kraft in den Festkörper 1 zum Erzeugen von Spannungen in dem Festkörper 1, wobei die äußere Kraft so stark ist, dass die Spannungen eine Rissausbreitung entlang der Ablöseebene 4 bewirkt.

Erfindungsgemäß werden in einem ersten Schritt die Modifikationen auf einer Linie 103 und bevorzugt im gleichen Abstand zueinander erzeugt. Weiterhin ist vorstellbar dass eine Vielzahl dieser im ersten Schritt erzeugten Linien erzeugt werden. Diese ersten Linien werden besonders bevorzugt parallel zur Rissausbreitungsrichtung uns bevorzugt geradlinig oder kreisbogenförmig, insbesondere in derselben Ebene, erzeugt. Nach der Erzeugung dieser ersten Linien werden bevorzugt zweite Linien 105 zum Auslösen und/oder Treiben von bevorzugt unterkritischen Rissen erzeugt. Diese zweiten Linien werden ebenfalls bevorzugt geradlinig erzeugt. Besonders bevorzugt sind die zweiten Linien gegenüber den ersten Linien geneigt, insbesondere orthogonal ausgerichtet. Die zweiten Linien erstrecken sich bevorzugt in derselben Ebene wie die ersten Linien oder besonders bevorzugt in einer Ebene die parallel zu der Ebene ist, in der sich die ersten Linien erstrecken. Anschließende werden bevorzugt dritte Linien erzeugt zum Verbinden der unterkritischen Risse erzeugt.

Dieses Verfahren ist insbesondere für das Abtrennen von Festkörperschichten von einem aus SiC bestehenden oder SiC aufweisenden Festkörper sinnvoll.

Ferner können die Modifikationen nacheinander in mindestens einer Zeile oder Reihe oder Linie erzeugt werden, wobei die in einer Zeile oder Reihe oder Linie erzeugten Modifikationen 2 bevorzugt in einem Abstand X und mit einer Höhe H erzeugt werden, damit ein sich zwischen zwei aufeinander folgenden Modifikationen ausbreitender Riss, insbesondere in Kristallgitterrichtung ausbreitender Riss, dessen Rissausbreitungsrichtung in einem Winkel W gegenüber der Ablöseebene ausgerichtet ist, die beiden Modifikationen miteinander verbindet. Der Winkel W liegt hierbei bevorzugt zwischen 2° und 6°, insbesondere bei 4°. Bevorzugt breitet sich der Riss von einem Bereich unterhalb des Zentrums einer ersten Modifikation hin zu einem Bereich oberhalb des Zentrums einer zweiten Modifikation hin aus. Der hierbei wesentliche Zusammenhang ist daher, dass die Größe der Modifikation in Abhängigkeit des Abstands der Modifikationen und des Winkels W verändert werden kann bzw. muss.

Ferner kann dieses Verfahren auch den Schritt des Erzeugens einer Kompositstruktur durch Anordnen oder Erzeugen von Schichten und/oder Bauteilen 150 an oder oberhalb einer zunächst freiliegenden Oberfläche des Festkörpers 1 aufweisen, wobei die freiliegende Oberfläche bevorzugt Bestandteil der abzutrennenden Festkörperschicht ist. Besonders bevorzugt werden die Modifikationen zum Ausbilden der Ablöseebene vor der Erzeugung der Kompositstruktur erzeugt.

Zum Einleiten der äußeren Kraft kann z.B. analog zu den zuvor beschriebenen Verfahren eine Aufnahmeschicht 140 an einer freiliegenden Oberfläche der Kompositstruktur bzw. des Festkörpers angeordnet werden.

Somit wird im weiteren erfindungsgemäßen Laserverfahren bevorzugt auf SiC (aber auch anderen Materialien) Linien parallel zur Rissausbreitungsrichtung (bevorzugt Querlinien genannt) erzeugt, um zunächst eine Ebene für die bevorzugte Rissauslösung zu definieren (Rissinitialisierung), bevor Längslinien die Risse treiben. Hierbei werden die Risse erst quer, dann längs initialisiert, bevor ein finaler Schritt Linien zwischen die Längslinien des zweiten Schritts setzt um die Risse vollflächig auszulösen. Dies ermöglicht kürzere Risslaufwege, was die finale Oberflächenrauhigkeit minimiert.

Beispielbild für Querlinien (mit dem Sägezahn) und Rissauslöselinien (auf den Wellenkämmen des Sägezahns).

**Bezugszeichenliste**

| | |
|---|---|
| 1 | Festkörper |
| 2 | Modifikation |
| 3 | Ort der Modifikationserzeugung |
| 4 | Rissführungsbereich |
| 6 | Festkörperanteil |
| 8 | Laserbeaufschlagungseinrichtung |
| 9 | Objektiv |
| 10 | Laserstrahlen |
| 11 | Modifizierte Laserstrahlen |
| 12 | Vertiefung |
| 14 | Festkörperschicht |
| 16 | Oberfläche der Festkörperschicht |
| 17 | Einstrahloberfläche |
| 18 | Spannungserzeugungsschicht oder Aufnahmeschicht 140 |
| 19 | Kleber oder weitere Spannungserzeugungsschicht |
| 24 | lokale Eigenschaftsveränderung des Festkörpers (z.B. der Transmission) |
| 26 | Graben |
| 28 | Rahmen |
| 30 | Kreuzungspunkt der reflektierten Strahlen |

32 Spülung

34 Beschichtung

300 Chuck

L Längsrichtung des Festkörpers

**Patentansprüche**

1. Verfahren zum Abtrennen einer Festkörperschicht (14), insbesondere einer Festkörperscheibe (14), von einem Festkörper (1), wobei das Verfahren aufweist:

Bereitstellen eines Festkörpers (1), Erzeugen von Modifikationen (2) im Inneren des Festkörpers (1) mittels LASER-Strahlen (10), die über eine Einstrahloberfläche (17) in den Festkörper (1) eindringen, wobei durch die Modifikationen (2) ein Rissführungsbereichs (4) vorgegeben wird, entlang dem eine Abtrennung der Festkörperschicht (14) von dem Festkörper (1) erfolgt,
**gekennzeichnet durch**:

Abtragen von Material des Festkörpers (2) in Längsrichtung (L) des Festkörpers (1), die orthogonal oder im Wesentlichen orthogonal zu der Einstrahloberfläche (17) ist, wobei durch den Materialabtrag der Rissführungsbereich (4) freigelegt wird, und Abtrennen der Festkörperschicht (14) von dem Festkörper (1), wobei der Festkörper im Rissführungsbereich (4) durch die Modifikationen derart geschwächt wird, dass sich die Festkörperschicht (1) infolge des Materialabtrags von dem Festkörper (2) ablöst, oder wobei nach dem Materialabtrag eine solche Anzahl an Modifikationen erzeugt wird, dass der Festkörper im Rissführungsbereich derart geschwächt wird, dass sich die Festkörperschicht (1) von dem Festkörper (2) ablöst, oder wobei eine Spannungserzeugungsschicht (18) an einer zur umlaufenden Oberfläche geneigt ausgerichteten Oberfläche (16) des Festkörpers (1) erzeugt oder angeordnet wird und durch ein thermisches Beaufschlagen der Festkörperschicht (14) mechanische Spannungen in dem Festkörper (1) erzeugt werden, wobei durch die mechanischen Spannungen ein Riss zum Abtrennen einer Festkörperschicht (14) entsteht, der sich ausgehend von der durch den Materialabtrag freigelegten Oberfläche des Festkörpers entlang der Modifikationen (2) ausbreitet, oder

wobei der Festkörper nach der Erzeugung der Modifikationen (2) thermisch beaufschlagt, insbesondere abgekühlt, wird und sich infolge der thermischen Beaufschlagung die Festkörperschicht (14) von dem Festkörper (1) entlang des Rissführungsbereichs (4) ablöst.

2. Verfahren nach Anspruch 1, wobei durch das Abtragen von Material des Festkörpers (1) eine umlaufende Vertiefung (12) erzeugt wird.

3. Verfahren nach Anspruch 1, wobei die geneigt ausgerichtete Oberfläche (16) eine ebene Oberfläche ist.

4. Verfahren nach Anspruch 1,

wobei der Materialabtrag ausgehend von einer freiliegenden Oberfläche des Festkörpers (1), insbesondere parallel zur Umfangsfläche des Festkörpers (1), in Längsrichtung (L) des Festkörpers (1) und zumindest abschnittsweise beabstandet zur Umfangsfläche des Festkörpers (1) erfolgt und/oder wobei der Materialabtrag in Form eines zumindest abschnittsweise kontinuierlich verlaufenden Grabens (26) erfolgt, wobei der Graben (26) von der Umfangsfläche beabstandet ist.

5. Verfahren nach Anspruch 4, wobei die freiliegende Oberfläche des Festkörpers (1) eine ebene Oberfläche ist.

6. Verfahren nach Anspruch 4, wobei der Graben mindestens $30\mu$m oder mindestens $100\mu$m oder mindestens $500\mu$m oder mindestens 1mm von der Umfangsfläche beabstandet ist.

**Claims**

1. Method for separating a solid body layer (14), in particular a solid body wafer (14), from a solid body (1), wherein the method comprises:

providing a solid body (1), generating modifications (2) in the interior of the solid body (1) by means of LASER beams (10) which penetrate into the solid body (1) via an irradiation surface (17), wherein a crack guide region (4) is predefined by the modifications (2), along which the solid body layer (14) is separated from the solid body (1),
**characterized by**:

removing material of the solid body (2) in the longitudinal direction (L) of the solid body (1), which is orthogonal or substantially orthogonal to the irradiation surface (17), wherein the crack guide region (4) is exposed by the material removal, and separating the solid body layer (14) from the solid body (1),

wherein the solid body is weakened in the crack guide region (4) by the modifications in such a way that the solid body layer (1) detaches from the solid body (2) as a result of the material removal, or

wherein such a number of modifications is generated after the material removal that the solid body is weakened in the crack guide region in such a way that the solid body layer (1) detaches from the solid body (2), or

wherein a stress-generating layer (18) is generated or arranged on a surface (16) of the solid body (1) oriented at an angle to the circumferential surface and mechanical stresses are generated in the solid body (1) by a thermal application of the solid body layer (14), wherein a crack for separating a solid body layer (14) arises as a result of the mechanical stresses, which propagates along the modifications (2) starting from the surface of the solid body exposed by the material removal, or

wherein the solid body is thermally exposed, in particular cooled, after the generation of the modifications (2) and the solid body layer (14) detaches from the solid body (1) along the crack guide region (4) as a result of the thermal application.

**2.** Method according to claim 1,
wherein a circumferential depression (12) is generated by the removal of material of the solid body (1).

**3.** Method according to claim 1,
wherein the surface (16) oriented at an angle is a planar surface.

**4.** Method according to claim 1,

wherein the material removal takes place starting from an exposed surface of the solid body (1), in particular parallel to the circumferential surface of the solid body (1), in the longitudinal direction (L) of the solid body (1) and at least in sections at a distance from the circumferential surface of the solid body (1), and/or

wherein the material removal takes place in the form of a trench (26) running continuously at least in sections, wherein the trench (26) is at a distance from the circumferential surface.

**5.** Method according to claim 4,
wherein the exposed surface of the solid body (1) is a planar surface.

**6.** Method according to claim 4,
wherein the trench is at a distance of at least 30 $\mu$m or at least 100 $\mu$m or at least 500 $\mu$m or at least 1 mm from the circumferential surface.


**Revendications**

**1.** Procédé pour séparer une couche (14) de corps solide, en particulier une tranche (14) de corps solide, d'un corps (1) solide,
procédé dans lequel :

on se procure un corps (1) solide,
on produit des modifications (2) au sein du corps (1) solide au moyen d'un rayonnement (10) laser, qui pénètre dans le corps (1) solide par une surface (17) d'incidence, dans lequel, par les modifications (2), on prescrit une partie (4) de guidage de fissure, le long de laquelle la couche (14) de corps solide se sépare du corps (1) solide,
**caractérisé en ce que**

on enlève de la matière du corps (2) solide dans la direction (L) longitudinale du corps (1) solide, qui est orthogonale ou sensiblement orthogonale à la surface (17) d'incidence, en mettant la partie (4) de guidage de fissure à découvert par l'enlèvement de matière, et
on sépare la couche (14) de corps solide du corps (1) solide,
dans lequel on affaiblit le corps solide dans la partie (4) de guidage de fissure par les modifications, de manière à ce que la couche (1) de corps solide se détache du corps (2) solide en raison de l'enlèvement de matière, ou
dans lequel, après l'enlèvement de matière, on produit un nombre tel de modifications, que l'on affaiblit le corps solide dans le guidage de fissure, de manière à ce que la couche (1) de corps solide se détache du corps (2) solide, ou
dans lequel on produit ou on met une couche (18) de production de contraintes sur une surface (16) du corps (1) solide dirigée de manière inclinée par rapport à la surface de contour et, par un traitement thermique de la couche (14) de corps solide, on produit des contraintes mécaniques dans le corps (1), dans lequel, par les contraintes mécaniques, il se crée une fissure pour la séparation d'une couche (14) de corps solide, qui se propage le long des modifications (2) à partir à la surface mise à découvert par l'enlèvement de matière, ou

dans lequel on traite thermiquement, en particulier en le refroidissant, le corps solide après la production des modifications (2) et, en raison du traitement thermique, la couche (14) du corps solide se détache du corps (1) solide le long de la partie (4) de guidage de fissure.

2. Procédé suivant la revendication 1, dans lequel on produit une cavité (12) de contour par l'enlèvement de matière du corps (1) solide.

3. Procédé suivant la revendication 1, dans lequel la surface (16) dirigée de manière inclinée est une surface plane.

4. Procédé suivant la revendication 1,

dans lequel l'enlèvement de matière à partir d'une surface mise à découvert, en particulier parallèlement à la surface de contour du corps (1) solide, s'effectue dans la direction (L) longitudinale du corps (1) solide et à distance au moins par endroit de la surface de contour du corps (1) solide et/ou

dans lequel l'enlèvement de matière s'effectue sous la forme d'un sillon (26) s'étendant d'une manière continue au moins par endroit, dans lequel le sillon (26) est à distance de la surface de contour.

5. Procédé suivant la revendication 4, dans lequel la surface à découvert du corps (1) solide est une surface plane.

6. Procédé suivant la revendication 4, dans lequel le sillon est à distance d'au moins 30 $\mu$m ou d'au moins 100 $\mu$m ou d'au moins 500 $\mu$m ou d'au moins 1 mm de la surface de contour.

Fig. 1

Fig. 2a

Fig. 2b

EP 4 166 270 B1

EP 4 166 270 B1

Fig. 3

Fig. 4a                    Fig. 4b

EP 4 166 270 B1

Fig. 5

Fig. 6a

Fig. 6b

Fig. 7

$P_{max}=0.90038$ for NA 0.4 and $\theta_{max}=52.525$

Fig. 8

$P_{max}$=0.87984 for NA 0.6 and $\theta_{max}$=35.556

Fig. 9

Fig. 10

Fig. 11

EP 4 166 270 B1

Fig. 12

Fig. 13

Fig. 14

Fig. 15

P_max=0.96581 for NA 0.4 and θ_max=41.212

Fig. 16

Fig. 17

Fig. 18

Fig. 19a

Fig. 19b

Fig. 19c

Fig. 19d

Fig. 20a   Fig. 20b   Fig. 20c   Fig. 20d   Fig. 20e   Fig. 20f

Fig. 21a

Fig. 21b

Fig. 22

Fig. 23b

Fig. 23a

Fig. 24a

Fig. 24b

EP 4 166 270 B1

Fig. 25a

Fig. 25b

Fig. 26a

Fig. 26b

EP 4 166 270 B1

Fig. 27a

Fig. 27b

Fig. 27c

Fig. 27d

Fig. 27e

Fig. 27f

Fig. 27g

Fig. 27h

Fig. 27i

Fig. 28

EP 4 166 270 B1

Fig. 29a

Fig. 29b

Fig. 29c

Fig. 29d

Fig. 30a

Fig. 30b

Fig. 30c

Fig. 31

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102014214940 A1

**In der Beschreibung aufgeführte Nicht-Patentliteratur**

- Optical Properties of Spin-Coated TiO2 Antireflection Films on Textured Single-Crystalline Silicon Substrates. International Journal of Photoenergy. Hindawi Publishing Corporation, vol. 2015, 8